# EUROPÄISCHE PATENTSCHRIFT

(11) **EP 3 050 412 B1**
(45) Veröffentlichungstag und Bekanntmachung des Hinweises auf die Patenterteilung: **26.09.2018**
(21) Anmeldenummer: 14738515.7
(22) Anmeldetag: 11.07.2014
(51) Int. Cl.: H05K 7/20, F24F 13/20, F24F 13/24, F24F 1/00, F24F 3/044

(54) **ANORDNUNG SOWIE VERFAHREN ZUM KÜHLEN EINES RAUMS**
ARRANGEMENT AND METHOD FOR COOLING A SPACE
SYSTÈME AINSI QUE PROCÉDÉ DE REFROIDISSEMENT D'UNE ENCEINTE

(30) Priorität: 24.09.2013 DE 202013008411 U
(43) Veröffentlichungstag der Anmeldung: 03.08.2016
(73) Patentinhaber: Weiss Klimatechnik GmbH, 35447 Reiskirchen-Lindenstruth (DE)
(72) Erfinder: KÖSTER, Mathias, 61231 Bad Nauheim (DE); SALOMON, Peter, 74915 Waibstadt (DE)
(74) Vertreter: Stoffregen, Hans-Herbert
(86) Internationale Anmeldenummer: PCT/EP2014/064920
(87) Internationale Veröffentlichungsnummer: WO 2015/043791

(56) Entgegenhaltungen:
- EP-A1- 2 587 173
- DE-B4-102011 117 988
- US-A- 5 277 036
- US-A1- 2002 166 334
- US-A1- 2005 061 013
- US-A1- 2008 194 195
- US-A1- 2008 273 306
- US-A1- 2011 232 861

## Beschreibung

Die Erfindung bezieht sich auf eine modulare Anordnung zum Kühlen eines Raums, dessen Durchtrittsöffnungen aufweisender Boden einen Hohlraum begrenzt, mit zumindest einem auf dem Boden aufgestellten Gehäuse, von dem zumindest eine erste Seitenwandung zumindest abschnittsweise, vorzugsweise vollständig, als Wärmetauscherfläche eines ersten Wärmetauschers und eine zweite Seitenwandung als Tür ausgebildet ist oder eine solche aufweist, sowie zumindest einem Ventilator, der im Hohlraum angeordnet ist, wobei der Ventilator strömungsmäßig mit Innenraum des Gehäuses verbunden ist.

Auch nimmt die Erfindung Bezug auf eine Anordnung zum Kühlen eines Raums, dessen Durchtrittsöffnungen aufweisender Boden einen Hohlraum begrenzt, umfassend zumindest einen eine Wärmetauscherfläche zur Verfügung stellenden ersten Wärmetauscher, ein auf dem Boden aufgestelltes Gehäuse quaderförmiger Geometrie mit einer ersten Seitenwandung, die zumindest abschnittsweise, vorzugsweise vollständig, mit dem zumindest einen ersten Wärmetauscher bzw. dessen Wärmetauscherfläche verschlossen ist, eine senkrecht zu der ersten Seitenwandung verlaufenden zweiten Seitenwandung mit einer Tür sowie der ersten Seitenwandung gegenüberliegenden dritten Seitenwandung als Rückseitenwandung, der zweiten Seitenwandung gegenüberliegender vierten Seitenwandung sowie die Seitenwandungen kopfseitig begrenzender Kopfwandung, zumindest einen in dem Hohlraum angeordneten Ventilator, der strömungsmäßig mit Innenraum des Gehäuses verbunden ist.

Gegenstand der Erfindung ist auch ein Verfahren zum Kühlen eines Raums mit einem Durchtrittsöffnungen aufweisenden einen Hohlraum begrenzenden Boden.

Der EP 2 278 231 A2 ist eine Anordnung zum Klimatisieren eines Raums zu entnehmen. Dabei ist ein Wärmetauscher als Raumbegrenzung bzw. Abschnitt einer Raumbegrenzung ausgebildet. Auf diese Weise ist der Raum energetisch günstig zu kühlen. Gleichzeitig kann eine problemlose Wartung des Wärmetauschers erfolgen, da dieser auf einer Seite von dem wärmeerzeugende Geräte enthaltenden Raum und auf raumabgewandter Seite von einem Wartungsgang begrenzt ist.

Der DE 10 2009 030 214 A1 und der DE 200 23 882 U1 sind Klimatisierungsanordnungen zu entnehmen, bei denen über Öffnungen eines Hohlbodens Luft in einen zu klimatisierenden Raum strömt, um im reinen Umluftbetrieb in dem Raum vorhandene wärmeerzeugende Geräte zu kühlen.

Aus der US 6 672 955 B1 ist ein Rechenzentrum bekannt, in dem in Reihen angeordnete elektronische Geräte Warm- und Kaltgänge begrenzen. Die Kaltgänge sind eingehaust, um in diese über einen Zwischenboden gekühlte Luft zuzuführen. Die die elektrischen Geräte durchströmende Luft wird sodann im Deckenbereich abgesaugt, die anschließend ein Wärmetauscher durchsetzt, der von einem Kühlfluid durchströmt wird.

Um Rechner zu kühlen, werden diese nach der DE 20 2004 003 309 U1 in einem doppelwandigen zylinderförmig geformten Rechnergehäuse angeordnet, das Lufteinlassöffnungen aufweist, durch die Kühlluft hindurch strömt, um die Rechner zu kühlen. Die erwärmte Luft wird sodann über einen Luftkanal abgeführt, in dem ein Ventilator angeordnet ist. Die Abluft kann wahlweise als Fortluft abgeführt werden oder im Kreislauf strömen, um nach Durchströmen einer Kühleinrichtung dem Raum erneut zugeführt zu werden, in dem sich das Rechnergehäuse befindet.

Nach der EP 1 488 305 B1 wird in einem Schrank angeordneten wärmeerzeugenden Geräten gekühlte Luft zugeführt, die über einen in einem Klimagerät angeordneten Ventilator abgesaugt wird. Im Strömungsweg zum Ventilator ist in dem Klimagerät ein Wärmetauscher angeordnet.

Um einen Raum zu kühlen, in dem Rechner in Reihen angeordnet sind, sieht die DE 200 23 882 U1 einen in dem Raum angeordneten Klimaschrank und einen in einem Hohlbodenraum angeordneten Ventilator vor, über den die Abluft durch den Klimaschrank gesaugt wird, um sodann die Zuluft über eine Bodenöffnung dem Raum wieder zuzuführen.

Der DE 20 2004 003 309 U1 ist eine Cluster-Kühlung zu entnehmen, wobei Abluft aus einem von Rechnern umgebenden zylindrischen Raum wahlweise als Fortluft abgeführt oder einem Klimagerät zugeführt wird.

Gegenstand der WO 2006/124240 A1 ist eine Kühlanordnung für Rechner, wobei in einem Zwischenraum ein Wärmetauscher angeordnet ist.

Nach der US 2004/0099747 A1 ist in einem Rechnerraum ein gesondertes Klimagerät angeordnet.

Aus der DE 20 2009 002 033 A ist eine Anordnung zum Klimatisieren eines Raums bekannt. An einer Wand ist ein Klimagerät angeordnet, dem Außenluft und/oder Abluft zuführbar ist.

Gegenstand der DE 10 2011 117 988 B4 ist eine Kühlanordnung zum Kühlen von in einem Raum in Schaltschränken angeordneten elektronischen Geräten. In dem die Geräte enthaltenden Raum befinden sich zwei quaderförmige turmartige Wärmetauscherschränke, die an mindestens zwei vertikalen Seitenflächen Wärmetauscher aufweisen. Der Schrank ist auf einem Öffnungen aufweisenden Doppelboden angeordnet, dem aus dem Wärmetauscherschrank austretende gekühlte Luft dem Raum zugeführt wird. Unterhalb des Schranks im Doppelboden kann ein Radiallüfter angeordnet sein, um die gekühlte Luft zu fördern. Alternativ besteht die Möglichkeit, den Radiallüfter oberhalb des Schrankes oder innerhalb von diesem nahe dessen Oberseite anzuordnen.

Der DE 10 2012 218 873 A1 sind Elektronik-Racks zu entnehmen, die eine Einlass- und Auslasstür aufweisen Dabei sind in den Auslasstüren der Racks Kühleinrichtungen integriert.

Weiterbildungen entsprechender Racks sind der US 7,385,810 B1 zu entnehmen.

Die US 2010/0041327 A1 bezieht sich auf ein Klimatisierungsgerät mit integralen Ventilatoren.

Gegenstand der DE 20 2013 100 519 U1 ist ein modulares Rechenzentrum. Dabei sind in einem Doppelboden Klimamodule angeordnet.

Ein portables Rack ist aus der US 2012/0155027 A1 bekannt, das mit einer Kühleinrichtung verbunden werden kann.

Ein in einem Container vorhandenes Rechenzentrum wird in der US 2012/0281357 A1 beschrieben, in dem außerdem eine Kühlanordnung angeordnet ist.

Um ein wärmeerzeugende Geräte enthaltendes Gehäuse zu kühlen, wird dieses nach der US 2005/0061013 A1 frontseitig mit einer Kühleinrichtung verschlossen.

Die US 2008/0273306 A1 sieht zur Kühlung von in Gehäusen angeordneten wärmeerzeugenden Geräten Kühlstationen vor, mit denen die Rückseiten der Gehäuse verschlossen werden.

Der vorliegenden Erfindung liegt unter anderem die Aufgabe zugrunde, eine Anordnung und ein Verfahren zuvor beschriebener Art so weiterzubilden, dass mit konstruktiv einfachen Maßnahmen im gewünschten Umfang eine Kühlung möglich ist, wobei eine problemlose Anpassung der Kühlleistung an die anfallende Wärmelast erfolgen soll. Gleichzeitig sollen die Vorteile von Anordnungen erzielbar sein, bei denen die Kühlung mittels eines in einer Begrenzung des Raums integrierten Wärmetauschers erzielbar sind, ohne die konstruktiven Nachteile zu übernehmen, insbesondere bauseitige Änderungen vornehmen zu müssen.

Zur Lösung der Aufgabe sieht die Erfindung im Wesentlichen vor, dass die Anordnung modular aufgebaut ist mit einem dann die Wärmetauscherfläche bildenden zumindest einen ersten Wärmetauscher als erstes Modulteil, dem Gehäuse als zweites Modulteil und dem Ventilator als drittes Modulteil, wobei das Gehäuse oder Teile des Gehäuses zur Vergrößerung der Wärmetauscherfläche für zumindest ein weiteres an dieses anreihbares Gehäuse oder anreihbare Gehäuseteile nutzbar ist bzw. sind. Dabei sollte das Gehäuse eine Quaderform mit die Wandungen begrenzenden Rahmen aufweisen.

Erfindungsgemäß wird ein modulares System zur Verfügung gestellt, mit dem ein Raum im erforderlichen Umfang gekühlt werden kann. Modulares System bedeutet dabei auch, dass entsprechende Gehäuse aneinanderreihbar sind, um im erforderlichen Umfang Wärmetauscherflächen zur Verfügung zu stellen, so dass die in dem Raum vorhandene Wärme abgebenden Geräte in Abhängigkeit von der anfallenden Wärmelast im erforderlichen Umfang gekühlt werden können. Modular bedeutet ferner, dass insbesondere Teile eines Gehäuses für weitere an dieses anreihbare Gehäuse bzw. Gehäuseteile benutzt werden können, so dass infolge dessen mit konstruktiv einfachen Maßnahmen eine Wärmetauscherfläche gewünschter Größe zur Verfügung gestellt werden kann. Somit können die Vorteile erzielt werden, die durch Anordnungen gegeben sind, bei denen eine Begrenzungswandung eines Raums zumindest abschnittsweise als Wärmetauscherfläche ausgebildet ist, ohne selbst eine diesbezügliche Abtrennung in dem Raum vornehmen zu müssen.

Durch den modularen Aufbau ergibt sich insbesondere der Vorteil, dass Kühlanordnungen zur Verfügung gestellt werden können, deren Abmessungen größer als die der Einbringöffnung des Raums sind, der gekühlt werden soll. So müssen nach dem Stand der Technik die die Kühlung ermöglichenden Gehäuse dimensionsmäßig an die Einbringöffnung des Raums abgestellt werden, so dass Breite bzw. Tiefe der Geräte bei üblichen Einbringöffnungen nicht mehr als etwa 90 cm betragen dürfen, sofern das Standardmaß 94,4 cm ist. Demgegenüber besteht erfindungsgemäß die Möglichkeit, bei Weitem größer dimensionierte Geräte aufzustellen; denn an die Einbringöffnung muss ausschließlich das größte Modul angepasst sein und nicht das Gerät selbst. Somit besteht ohne Weiteres die Möglichkeit, Klimageräte mit Ventilatoren zu betreiben, die unterhalb des Klimagerätes im Zwischenboden angeordnet werden und Laufräderabmessungen aufweisen, die z. B. 710 mm oder 800 mm betragen können. Demgegenüber werden nach dem Stand der Technik aufgrund der Beschränkung der Abmessungen des Klimagerätegehäuses Ventilatoren mit einem Laufraddurchmesser von 630 mm grundsätzlich nicht überschritten.

Insbesondere sieht die Erfindung vor, dass das Gehäuse mit einem Gehäuseteil verbunden ist, das aus einer in die Kopfwandung des Gehäuses übergehende Kopfwandung und einer Seitenwandung besteht, die in diejenige des Gehäuses übergeht, die den Wärmetauscher nicht aufweist. Der zuvor mit dem Gehäuse verbundene erste Rahmen, der die Tür aufweist, wird von dem Gehäuse entfernt und stirnseitig mit dem Gehäuseteil verbunden. In die verbleibenden ineinander übergehenden Seitenflächen des Gehäuses und des Gehäuseteils ist sodann zumindest ein Wärmetauscher eingesetzt, um eine Wärmetauscherfläche zur Verfügung zu stellen. Folglich sind nur wenige Bauteile erforderlich, um eine Wärmetauscherfläche gewünschter Größe zur Verfügung zu stellen, ohne dass vollständige Gerätegehäuse benutzt werden müssen, wie dies z. B. nach DE 10 2011 117 988 B4 der Fall ist.

Die Erfindung zeichnet sich folglich des Weiteren dadurch aus, dass das erste Gehäuse modular derart aufgebaut ist, dass die Tür von dem ersten Rahmen aufgenommen ist, dass der erste Rahmen von dem Gehäuse lösbar ist und das mit verbleibendem Gehäuseteil ein weiteres Gehäuse bzw. Gehäuseteil verbindbar ist, wobei der erste Rahmen mit der Tür eine äußere Stirnwandung des weiteren Gehäuses bzw. Gehäuseteils bildet.

Selbstverständlich wird die Erfindung auch dann nicht verlassen, wenn zum Einsetzen des Gehäuses nicht der die Tür aufweisende Rahmen, sondern die gegenüberliegende Seitenwandung zunächst entfernt und sodann mit dem eingesetzten Gehäuseteil verbunden wird.

Insbesondere ist Gegenstand der Erfindung eine Anordnung zum Kühlen eines Raums, dessen Durchtrittsöffnungen aufweisender Boden einen Hohlraum begrenzt, umfassend
- zumindest einen eine Wärmetauscherfläche zur Verfügung stellenden ersten Wärmetauscher,
- ein auf dem Boden aufgestelltes Gehäuse quaderförmiger Geometrie mit einer ersten Seitenwandung, die zumindest abschnittsweise, vorzugsweise vollständig, mit dem zumindest einen ersten Wärmetauscher bzw. dessen Wärmetauscherfläche verschlossen ist, eine senkrecht zu der ersten Seitenwandung verlaufenden zweiten Seitenwandung mit einer Tür sowie der ersten Seitenwandung gegenüberliegenden dritten Seitenwandung als Rückseitenwandung, der zweiten Seitenwandung gegenüberliegender vierten Seitenwandung sowie die Seitenwandungen kopfseitig begrenzender Kopfwandung,
- zumindest einen in dem Hohlraum angeordneten Ventilator, der strömungsmäßig mit Innenraum des Gehäuses verbunden ist.

Die diesbezügliche Anordnung zeichnet sich dadurch aus, dass die Anordnung modular aufgebaut ist mit
- dem zumindest einen ersten Wärmetauscher als erstes Modulteil,
- dem Gehäuse als zweites Modulteil,
- dem zumindest einen Ventilator als drittes Modulteil,
wobei der zumindest eine erste Wärmetauscher von einem die erste Seitenwandung begrenzenden Rahmen oder Abschnitte eines solchen aufgenommen ist, die Tür mit einem die zweite Seitenwandung begrenzenden oder aufweisenden ersten Rahmen verbunden ist, der einen Längsrahmenschenkel aufweist, der in einer Ebenen verläuft, die von der ersten Seitenwandung aufgespannt ist, wobei zur Erweiterung der Kühlleistung der Anordnung zwischen dem ersten Rahmen mit der Tür zumindest ein Gehäuseteil als viertes Modulteil eingesetzt ist, das aus einem bündig in die Kopfwandung übergehenden Kopfteil und einem bündig in die Rückseitenwandung übergehendes Rückseitenteil besteht, und wobei zwischen dem ersten Längsrahmenschenkel und dem zumindest einen ersten Wärmetauscher ein zweiter Wärmetauscher angeordnet ist.

Dabei besteht die Möglichkeit, dass zur Erweiterung der Kühlleistung der Anordnung anstelle zwischen dem ersten Rahmen und verbleibendem Gehäuse zwischen der der zweiten Seitenwandung gegenüber liegenden vierten Seitenwandung und dem verbleibenden Gehäuseteil ein viertes Modulteil oder mehrere vierte Modulteile eingesetzt ist bzw. sind.

Ein erfindungsgemäßes Merkmal ist, dass von den aneinander gereihten Gehäusen bzw. -teilen ineinander übergehende Seitenwandungen als Wärmetauscher ausgebildet sind, die insbesondere auf Stoß aneinandergrenzen. Dabei sollte insbesondere die die Tür aufweisende Seitenwandung senkrecht zu dem Wärmetauscher bzw. den Wärmetauschern verlaufen.

Insbesondere ist vorgesehen, dass ein Gehäuse mit einem oder mehreren Gehäuseteilen aneinandergereiht eine Gehäuseeinheit bildet, deren eine Längsseitenfläche als Wärmetauscherfläche ausgebildet ist.

Ein weiteres die Erfindung kennzeichnendes Merkmal ist, dass der dem Gehäuse zugeordnete zumindest eine Ventilator in Projektion des Gehäuses in Richtung des Bodens unterhalb von dem Gehäuse angeordnet ist und mit dem Boden verbunden und/oder auf der Bodenfläche des Hohlraums aufgeständert ist.

Insbesondere sieht die Erfindung jedoch vor, dass dem ersten Gehäuse zwei Ventilatoren zugeordnet sind, deren Saugseiten innerhalb der Bodenfläche des Gehäuses verlaufen. Vorzugsweise weist jedes weitere Gehäuseteil, das mit dem Gehäuseteil oder mit einem weiteren Gehäuseteil verbunden ist, zwei zugeordnete Ventilatoren auf, deren Saugseiten innerhalb der jeweiligen das weitere Gehäuseteil abstützenden Bodenfläche verlaufen.

Um den Wärmetauscher gegenüber dem Gehäuse bzw. Gehäuseteil bzw. dessen Rahmen bzw. Rahmenteilen im erforderlichen Umfang abzudichten, sieht eine Weiterbildung der Erfindung vor, dass der Wärmetauscher auf Stoß mit dem von einem als fünften Rahmen bezeichneten die Seitenwandung umgebenen Rahmen verbunden ist oder umfangsseitig von dem fünften Rahmen umgeben ist und gegenüber diesem z. B. mittels einer Moosgummidichtung abgedichtet ist.

Vorzugsweise kann der Wärmetauscher in den fünften Rahmen hineingeschoben werden, so dass eine problemlose Montage erfolgt. Dabei ist insbesondere vorgesehen, dass der Wärmetauscher mit einer Begrenzung, insbesondere Deckenwandung des Raums verbunden ist, so dass das Gehäuse bzw. Gehäuseteil selbst befestigungslos auf dem Boden aufgestellt werden kann. Hierdurch ergibt sich eine weitere Montagevereinfachung.

Der Wärmetauscher selbst sollte gehäuseaußenseitig mit einer perforierten Abdeckung wie einem perforierten Blech versehen sein. Zwischen diesem und dem Wärmetauscher kann des Weiteren ein Filter vorgesehen sein.

Ein weiteres hervorzuhebendes Merkmal der Erfindung ist, dass zumindest die das erste Gehäuse bzw. die weiteren Gehäuseteile aufnehmenden Bereiche des Bodens auf der Bodenfläche des Hohlraums aufgeständert ist und dass in diesem Bereich der bzw. die Ventilator(en) mit dem aufgeständerten Boden verbunden ist bzw. sind.

Die Erfindung zeichnet sich auch dadurch aus, dass die Anordnung aus aneinandergereihten und begehbaren Gehäuse und einem oder mehreren Gehäuseteilen besteht, dass eine Längsseite der aneinandergereihten Gehäuse und -teile als Wärmetauscherfläche ausgebildet ist, die durch auf Stoß ineinander übergehende Wärmetauscher gebildet ist, dass zumindest eine Stirnwand der aneinandergereihten Gehäuse und -teile zumindest bereichsweise als Tür ausgebildet ist, die von einem ersten Rahmen aufgenommen ist, der mit zugeordnetem endseitigen Gehäuseteil verbunden ist, und dass jedem Gehäuse bzw. -teil zumindest ein mit das Gehäuse bzw. - teil abstützendem Bodenbereich verbundener Radialventilator zugeordnet ist.

Die Erfindung sieht in Weiterbildung vor, dass zumindest eine Außenseite des Gehäuses und/oder des mit diesem verbundenen zumindest einen Gehäuseteils von zumindest einer Innenwandung des Raums begrenzt ist, wobei die entlang der zumindest einen Innenwandung verlaufende Wandung des Gehäuses bzw. des zumindest einen Gehäuseteils entfernt ist. Somit bildet der Raum selbst Begrenzung des Gehäuses bzw. der aus dem Gehäuse und dem zumindest einem Gehäuseteil gebildeten Einheit.

Des Weiteren kann der Wärmetauscher von einem Rahmen umgeben sein, der gegenüber dem fünften Rahmen des Gehäuses und des gegebenenfalls vorhandenen zumindest einen Gehäuseteils und bei aneinandergereihten Wärmetauschern ergänzend gegenüber angrenzenden Wärmetauschern abgedichtet ist.

Die Anordnung zeichnet sich erfindungsgemäß auch dadurch aus, dass in dem Raum in Reihen angeordnete Wärme erzeugende Geräte in Gestellen (Racks) angeordnet sind, wobei ein Rack oder ein Abschnitt von diesem durch ein Gehäuse oder durch ein Gehäuse und zumindest ein mit diesem verbundenes erfindungsgemäßes Gehäuseteil ersetzt ist.

Insbesondere bezieht sich die Erfindung auf ein Verfahren zum Kühlen eines Raums mit einem Durchtrittsöffnungen aufweisenden einen Hohlraum begrenzenden Boden, das durch die Verfahrensschritte gekennzeichnet ist,
- Anordnen einer modular aufgebauten Anordnung in dem Raum, umfassend ein quaderförmiges Gehäuse mit einer als Wärmetauscherfläche zumindest eines ersten Wärmetauschers ausgebildeten ersten Seitenwandung, einer senkrecht zu dieser verlaufenden von einem ersten Rahmen begrenzten zweiten Seitenwandung mit einer Tür, wobei der erste Rahmen einen Längsschenkel aufweist, der in einer Ebene verläuft, die von der ersten Seitenwandung aufgespannt wird, einer der ersten Seitenwandung gegenüberliegenden dritten Seitenwandung als Rückseitenwandung, einer der zweiten Seitenwandung gegenüberliegenden vierten Seitenwandung mit einem diese aufspannenden dritten Rahmen mit Längsschenkel, der in der Ebene verläuft, die von der ersten Seitenwandung aufgespannt wird, einer die Seitenwandungen kopfseitig begrenzenden Kopfwandung sowie zumindest einen unterhalb des Gehäuses in dem Hohlraum angeordneten und strömungsmäßig mit dessen Innenraum verbundenen Ventilator, wobei das Gehäuse ein erstes Modulteil, der zumindest eine erste Wärmetauscher ein zweites Modulteil und der zumindest eine Ventilator ein drittes Modulteil bilden,
- wobei zur Erweiterung der Kühlleistung der erste und/oder dritte Rahmen entfernt wird, mit dem verbleibenden Restgehäuse ein weiteres Gehäuseteil als viertes Modulteil verbunden wird, das ein mit der Kopfwandung des Restgehäuses zu verbindendes Kopfteil und ein mit der Rückseitenwandung des Restgehäuses zu verbindendes Rückenteil aufweist,
- der erste und/oder dritte Rahmen mit dem weiteren Gehäuseteil verbunden wird und
- in den von dem Längsschenkel des ersten und/oder dritten Rahmens, dem Kopfteil des eingesetzten Gehäuseteils sowie dem im Restgehäuse vorhandenen zumindest einen ersten Wärmetauscher umgebenen Freiraum ein weiterer Wärmetauscher eingesetzt wird, dessen Wärmetauscherfläche auf die des ersten Wärmetauschers ausgerichtet wird.

Nach einer Weiterbildung ist vorgesehen, dass zwischen dem ersten und/oder dritten Rahmen und dem verbleibenden Gehäuse mehrere entsprechende Gehäuseteile und entsprechende Wärmetauscher angeordnet werden.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von der Zeichnung zu entnehmenden bevorzugten Ausführungsbeispielen.

Es zeigen:
- Fig. 1: eine modulare Einheit aus Gehäuse, Wärmetauscher und Ventilatoren in perspektivischer Darstellung,
- Fig. 2: die Anordnung gemäß Fig. 1 von der Rückseite her,
- Fig. 3: die Anordnung gemäß Fig. 1 in Richtung der hinteren Stirnseite betrachtet,
- Fig. 4: eine Schnittdarstellung entlang der Linie B-B in Fig. 3,
- Fig. 5: die Anordnung gemäß Fig. 1 in Draufsicht,
- Fig. 6: die Anordnung gemäß Fig. 1 in Explosionsdarstellung,
- Fig. 7: eine Anordnung mit einem Gehäuse und mit diesem verbundenem Gehäuseteil in perspektivischer Darstellung in Richtung einer Tür,
- Fig. 8: die perspektivische Darstellung gemäß Fig. 7 in Richtung der der Tür gegenüberliegenden Stirnwandung,
- Fig. 9: die Anordnung gemäß Fig. 7 und 8 in Draufsicht,
- Fig. 10: eine Explosionsdarstellung der den Fig. 1 - 6 zu entnehmenden Anordnung oberhalb eines als Standfläche für wärmeerzeugende Geräte dienenden Bodens,
- Fig. 11: ein das Gehäuseteil zu verbindenden mit dem den Fig. 1 - 6 und 10 zu entnehmenden Gehäuse zur Bildung der Einheit gemäß den Fig. 7 - 9,
- Fig. 12 - 16: verschiedene Positionierungen einer erfindungsgemäßen Anordnung in einem Raum,
- Fig. 17: eine erfindungsgemäße Anordnung in Explosionsdarstellung ähnlich der Fig. 10,
- Fig. 18: Modulteile der erfindungsgemäßen Anordnung,
- Fig. 19: die zusammengesetzte erfindungsgemäße Anordnung ähnlich der Fig. 1, in einer ersten perspektivischen Darstellung,
- Fig. 20: die Anordnung gemäß Fig. 19 in einer zweiten perspektivischen Darstellung,
- Fig. 21: einen Abschnitt eines Bodens mit einem ein Modulteil bildenden Ventilator,
- Fig. 22: ein Gehäuseteil zur Erweiterung einer erfindungsgemäßen Anordnung,
- Fig. 23: Wärmetauscher und Ventilator einer erfindungsgemäßen Anordnung, verbunden mit einem Abschnitt eines aufgeständerten Bodens,
- Fig. 24: eine perspektivische Darstellung eines Abschnittes eines Bodens mit Ventilatoren sowie eine Anordnung zum Kühlen eines Raums, vorbereitet zur Erweiterung der Kühlleistung,
- Fig. 25: teilweise in Explosionsdarstellung die Anordnung gemäß Fig. 24 mit zur Erweiterung der Kühlleistung verwendeten Modulteilen,
- Fig. 26: die Anordnung gemäß Fig. 25, teilweise zusammengebaut und
- Fig. 27: die Anordnung gemäß der Fig. 25 und 26 im zusammengebauten Zustand.

In den Figuren, in denen grundsätzlich gleiche Elemente mit gleichen Bezugszeichen versehen sind, sind Prinzipdarstellungen von Anordnungen wiedergegeben, um einen Raum zu kühlen, in dem insbesondere in Reihen wärmeerzeugende Geräte wie Server angeordnet sind, die Kalt- und Warmgänge begrenzen, ohne dass dies ein zwingendes Merkmal ist. Die wärmeerzeugenden Geräte sind dabei üblicherweise in sogenannten Racks (Gestellen) angeordnet, die ein Rastermaß aufweisen können.

Bei der Kühlung nutzt man die Technik, dass Begrenzungen eines oder mehrerer in dem Raum aufgestellter Gehäuse abschnittsweise als Wärmetauscher ausgebildet sind, um Warmluft, die aus dem Raum abgeführt wird, zu kühlen. Dies schließt jedoch nicht aus, dass zusätzlich Außenluft dem Raum zugeführt wird. Entsprechend wird Fortluft aus dem Raum abgeführt.

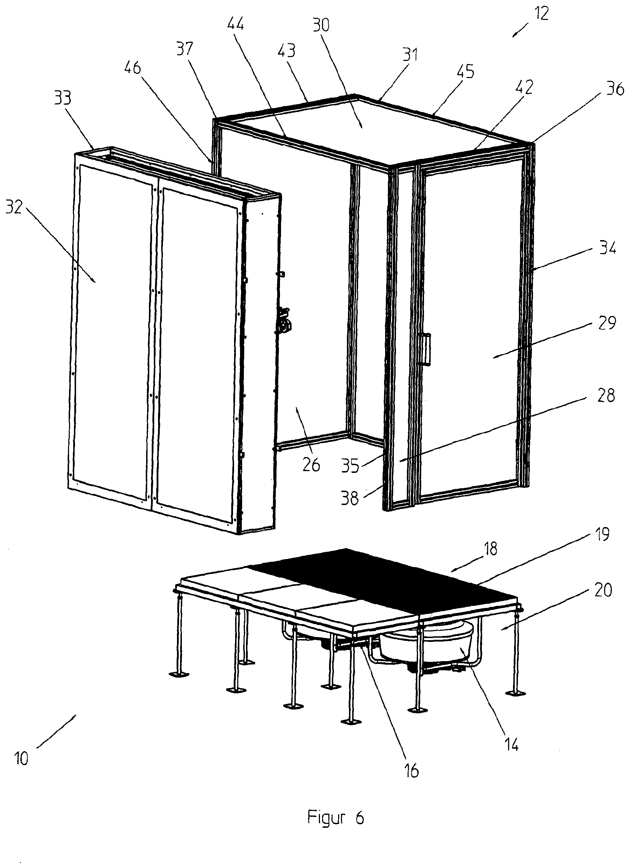

Um kostengünstig und mit konstruktiv einfachen Maßnahmen im erforderlichen Umfang eine Kühlung vorzunehmen, ist erfindungsgemäß ein modulares System vorgesehen, dass entsprechend der Fig. 6 ein Gehäuse 12, einen Wärmetauscher 32 und zumindest einen Ventilator 14, 16 umfasst, der unterhalb eines Bodens 18 angeordnet ist, auf dem das Gehäuse 12 mit dem Wärmetauscher 12 sowie die in den Figuren nicht dargestellten Wärme erzeugenden Geräte in einem gleichfalls nicht gezeichneten Raum angeordnet sind. Der Boden 18 ist entsprechend den zeichnerischen Darstellungen aufgeständert, um einen Hohlraum oder Zwischenboden 20 zu bilden, der von dem Boden 18 und einem Gebäudeboden begrenzt wird. Auf diesem ist der Boden 18 aufgeständert. Insoweit wird jedoch auf konstruktive Maßnahmen verwiesen, die im Zusammenhang mit zu kühlenden Rechnerräumen hinlänglich bekannt sind und dem eingangs genannten Stand der Technik zu entnehmen sind.

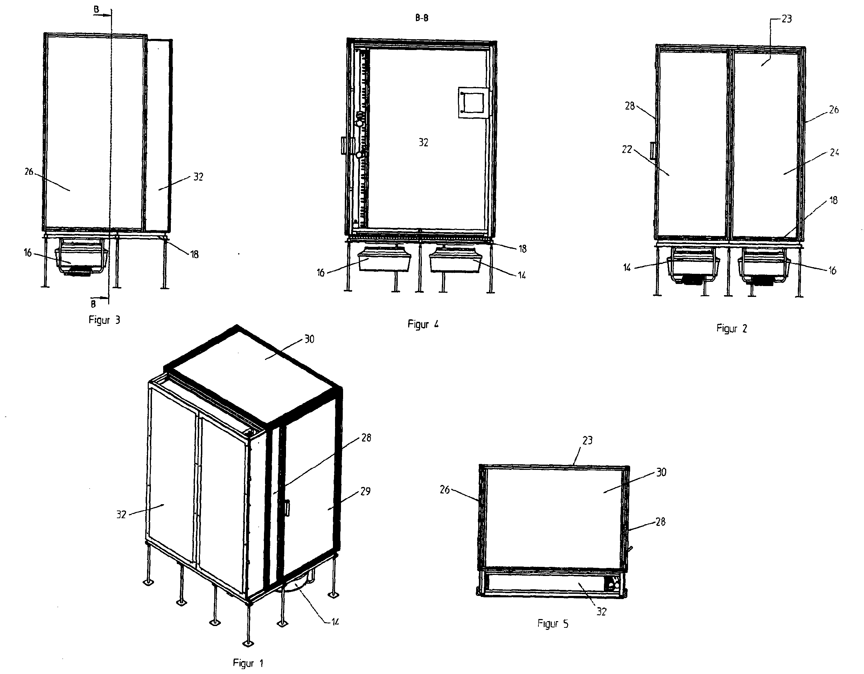

Die den Fig. 1 - 6 und 10 zu entnehmende Anordnung 10 umfasst erwähntermaßen als kleinste Einheit das Gehäuse 12 mit einer durch Abschottelemente 22, 24 gebildeten geschlossenen Rückseitenwandung 23, einer Stirnseitenwandung 26 und einer gegenüberliegenden eine Tür 29 aufweisende Stirnseitenwandung 28 sowie einer Kopfwandung 30. Die verbleibende parallel zu der Rückseitenwandung 22, 24 verlaufende und als erste Seitenwandung bezeichnete Seitenwandung wird durch den Wärmetauscher 32 verschlossen, so dass durch diesen strömende Warmluft gekühlt werden kann.

Dabei wird der Rahmen der die Tür 29 aufweisenden Stirnseitenwandung 28 als erster Rahmen 35 bezeichnet, der Längsschenkel 34, 38 und einen kopfseitigen Querschenkel 36 umfasst.

Die den Wärmetauscher 32 aufweisende Seitenwandung wird von einem als fünften Rahmen bezeichneten Rahmen 37 umgeben, der in dem Gehäuse 12 von dem Längsschenkel 38, einem gegenüber liegenden Längsschenkel 46 und einem kopfseitig verlaufenden Querschenkel 44 begrenzt wird. Bodenseitig weist der den Wärmetauscher 32 aufnehmende Rahmen keinen Schenkel auf, gleichwenn dies möglich wäre.

Der in Fig. 6 dargestellte vordere Längsschenkel 38 ist der Längsschenkel des ersten Rahmens 35, der die Tür 29 aufnimmt bzw. innerhalb der sich die Tür 29 befindet.

Der Längsschenkel 46 ist der Längsschenkel des als dritter Rahmen 27 bezeichneten Rahmens der Stirnseite bzw. Stirnseitenwandung 26, die der Tür 29 gegenüberliegt. Der Querschenkel 44 ist der wärmetauscherseitig verlaufende Längsschenkel des als zweiter Rahmen 31 bezeichneten Rahmens der Kopfwandung 30.

Der Bereich des Zwischenbodens 18, der von dem Gehäuse 12 und dem Wärmetauscher 32 umgeben wird, weist entsprechend den Darstellungen Durchbrechungen auf, um über den Innenraum durch den Wärmetauscher 32 hindurch angesaugte Luft in den Hohlboden 20 mittels der Ventilatoren 14, 16 zu fördern, bei denen es sich insbesondere um Radialventilatoren handelt.

Wie sich aus den zeichnerischen Darstellungen ergibt, sind der Anordnung 10 insgesamt zwei Ventilatoren 14, 16 zugeordnet, die über Halterungen mit dem Zwischenboden 18 verbunden sind. Die Saugseiten der Ventilatoren 14, 16 verlaufen unmittelbar unterhalb des Innenraums des Gehäuses 12.

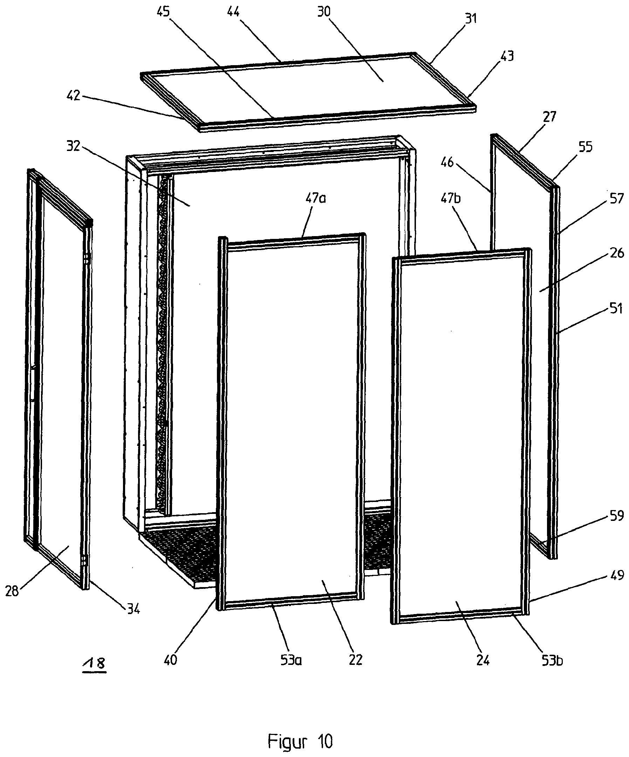

Das Gehäuse 12 selbst ist modular ausgebildet, wie sich aus der Fig. 10 ergibt. Dabei sind in dem als vierter Rahmen 49 bezeichneten Rahmen der Rückseitenwandung 23, dem (dritten) Rahmen 27 der Stirnwandung 26 und dem gegenüberliegenden (ersten) Rahmen 35 der die Tür 29 aufweisenden Stirnwandung 28 gemäß der zeichnerischen Darstellung transparente Elemente eingesetzt. Hierdurch erfolgt jedoch eine Beschränkung der Erfindung nicht. Vielmehr können auch z.B. Blechelemente eingesetzt sein. Des Weiteren ergibt sich aus der Zeichnung, dass die Tür 29 nur einen Bereich der Stirnwandung 28 einnimmt. Die Beschläge der Tür 29 gehen im Ausführungsbeispiel von dem in Fig. 6 rechts verlaufenden Längsrahmenschenkel 34 der Stirnwandung 28 aus. Des Weiteren weist die Stirnwandung 28 den kopfseitig verlaufenden Querschenkel 36 sowie den Längsschenkel 38 auf. Letzterer begrenzt die Seitenfläche, die von dem Wärmetauscher 32 verschlossen wird.

Der Längsschenkel 34 ist lösbar mit dem angrenzenden Längsschenkel 40 der Seitenwandung 23 bzw. des Abschottelements 22 verbunden. Der Querschenkel 36 des ersten Rahmens 35 ist lösbar mit dem Querschenkel 42 der Kopfwandung 30, also dem zweiten Rahmen 31, verbunden.

Der dem türseitigen Querschenkel 42 gegenüberliegende Querschenkel des zweiten Rahmens 31 der Kopfwandung 30 ist mit dem Bezugszeichen 43 gekennzeichnet.

Der gegenüberliegend zum wärmetauscherseitig verlaufenden Längsschenkel 44 des zweiten Rahmens 31 verlaufende Längsschenkel der Kopfwandung 30 trägt das Bezugszeichen 45. Der Schenkel 45 ist mit dem kopfseitig verlaufenden Querschenkel 47a, 47b der Rückseitenwandung 23 verbunden, der durchgehend ausgebildet sein kann, sofern die Rückseitenwandung 23 nicht aus mehreren Abschottelementen 22, 24 zusammengesetzt ist, wie dies im Ausführungsbeispiel der Fall ist. Insoweit werden die Abschottelemente 22, 24 insgesamt als die Rückseitenwandung 23 bezeichnet und stellen ein Synonym dar. Besteht die Rückseitenwandung 23 aus einem Element, so würde der kopfseitige Querschenkel mit dem Bezugszeichen 47 gekennzeichnet sein.

Der die Rückseitenwandung 23 begrenzende vierte Rahmen 49 wird von dem türseitig verlaufenden Längsschenkel 40, dem Querschenkel 47a, 47b, dem stirnrückseitig verlaufenden Längs schenkel 51 der rückseitigen Stirnwandung 26 und einem bodenseitig verlaufenden Schenkel gebildet, der im Ausführungsbeispiel aus den Abschnitten 53a, 53b besteht, da die Rückseitenwandung 23 aus den zwei Abschottelementen 22, 24 zusammengesetzt ist.

Die rückseitige Stirnseitenwandung 26, d. h. der dritte Rahmen 27, besteht aus dem wärmetauscherseitig verlaufenden Längsschenkel 46, dem kopfseitigen Querschenkel 55, dem mit dem Längsschenkel 51 der Rückseitenwandung 23 zu verbindenden Längsschenkel 57 und dem bodenseitigen Schenkel 59, der seinerseits in die Längsrahmenschenkel 46, 57 übergeht.

Aus Gründen der Vereinfachung werden erwähntermaßen der die Tür 29 aufnehmende Rahmen 35 als erster Rahmen, der Rahmen 31 der Kopfwandung 30 als zweiter Rahmen, der die rückseitige Stirnseite 26 aufspannende Rahmen 27 als dritter Rahmen und der im Ausführungsbeispiel aus den Abschottelementen 22, 24 gebildete Rahmen 49 als vierter Rahmen bezeichnet.

Der erste Rahmen 35 ist über den kopfseitigen Querschenkel 36 mit dem Querschenkel 42 des zweiten Rahmens 31 sowie mit dem Längsschenkel 40 des vierten Rahmens lösbar, insbesondere mittels Schrauben, verbunden. Der zweite Rahmen 31, also der der Kopfwandung 30, ist des Weiteren mit seinem Querschenkel 43 mit dem Querschenkel 55 des dritten Rahmens 27 und mit seinem Längsschenkel 45 mit den kopfseitigen Querschenkeln 47a, 47b des vierten Rahmens 49 verbunden. Die Längsschenkel 57 bzw. 51 des dritten Rahmens 27 und vierten Rahmens 49 sind gleichfalls lösbar verbunden, insbesondere über Schrauben.

Somit ist nicht nur die Anordnung 10 selbst, sondern das aus dem ersten Rahmen 35, dem zweiten Rahmen 31, dem dritten Rahmen 27 und dem vierten Rahmen 49 gebildete Gehäuse 12 gleichfalls modular aufgebaut.

Der Wärmetauscher 32 weist im Ausführungsbeispiel einen Rahmen 33 auf, der gegenüber einem fünften und die durch den Wärmetauscher 32 gebildete Seitenwandung umgebenden Rahmen 37 abgedichtet ist, der durch den Schenkel 38 des ersten Rahmens 35, den Schenkel 44 des zweiten Rahmens 31 und den Schenkel 46 des dritten Rahmens 27 gebildet wird. Vorzugsweise ist der Wärmetauscher 32 in den von den Schenkeln 38, 44, 46 gebildeten fünften Rahmen 37 einschiebbar und gegenüber diesem z. B. über Moosgummidichtungen abgedichtet. Eine entsprechende Abdichtung kann auch gegenüber dem Boden 18 erfolgen.

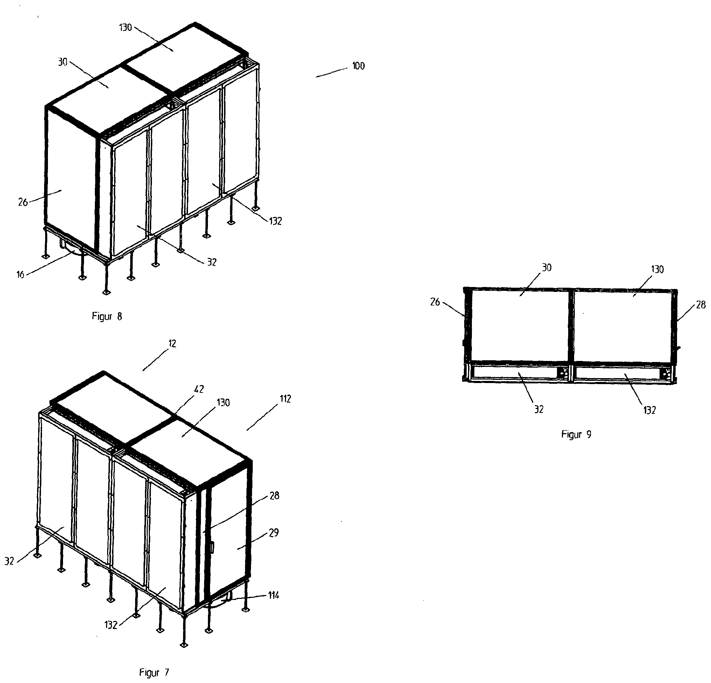

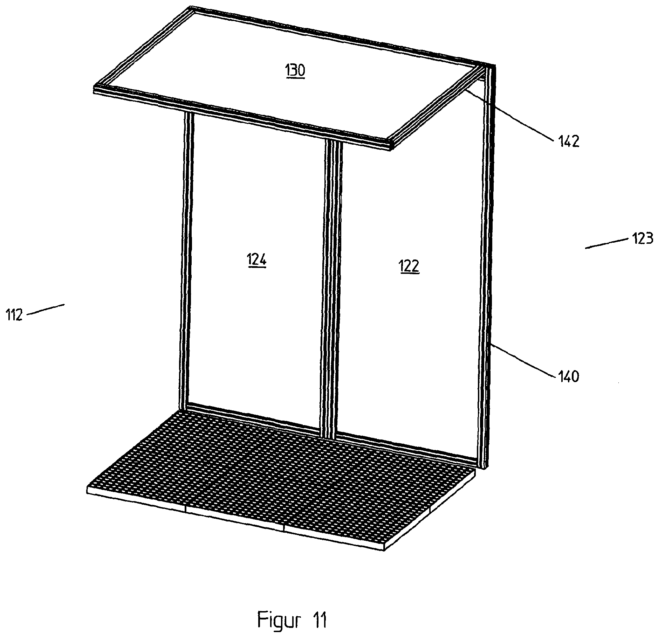

Um die Leistung zu erhöhen, also die Wärmetauscherfläche zu vergrößern, ist aufgrund der erfindungsgemäßen Lehre des modularen Aufbaus problemlos eine Erweiterung der Anordnung 10 möglich, ohne dass ein separates Gehäuse in dem zu kühlenden Raum angeordnet werden muss, wie dies nach dem Stand der Technik der Fall ist. Vielmehr ist es nur erforderlich, dass die die Tür 29 aufweisende Seitenwandung 28 von dem verbleibenden Teil des Gehäuses 12 - als Restgehäuse zu bezeichnen - entfernt wird, und sodann entsprechend der Fig. 11 eine weitere Seitenwandung 123 bestehend aus den Abschottelementen 122, 124 mit dem Schenkel 40 der Rückseitenwandung 23 sowie eine weitere Kopfwandung 130 mit dem Querschenkel 42 der Kopfwandung 30 verbunden wird, um sodann die gegenüberliegenden freien Schenkel 140, 142 der Kopfwandung 130 bzw. des Abschottelements 122 mit dem zuvor entfernten Rahmen 35 der Stirnwandung 28, also den Rahmenschenkel 34 und dem kopfseitig verlaufenden Querschenkel 36 zu verbinden. Sodann kann in die erweiterte frontseitig offene Stirnwandung ein weiterer Wärmetauscher 132 eingesetzt werden, wie sich aus den Fig. 7 - 9 ergibt, die selbsterklärend sind.

Es werden folglich das Gehäuse 12 und das Gehäuseteil 112 aneinandergereiht, wobei zuvor von dem Gehäuse 12 der die Tür 29 aufweisende erste Rahmen 35 entfernt und nach Verbinden des Gehäuseteils 112 mit dem Gehäuse 12 mit den verbleibenden stirnseitig verlaufenden Schenkeln 140, 142 des Gehäuseteils 112 verbunden wird. Hierdurch ergibt sich auch die Möglichkeit, da der die Tür 29 aufnehmende erste Rahmen 35 zuvor von dem Gehäuse 12 entfernt worden ist, dass die Wärmetauscher 32, 132 auf Stoß miteinander verbunden werden, also ein Zwischenraum nicht vorhanden ist; denn der die Tür 29 aufnehmende erste Rahmen 35 ist mit den stirnseitigen Bereichen sowohl des Querschenkels 42 der Kopfwandung 30 als auch des Längsrahmenschenkels 40 des Abschottelements 22 der Rückseitenwandung 23 verbunden.

Das Gehäuseteil 112 weist entsprechend der zeichnerischen Darstellung eine Länge auf, die der des Gehäuses 12 entspricht, so dass dimensionsmäßig gleiche Wärmetauscher sowohl für das Gehäuse 12 als auch für das Gehäuse 112 eingesetzt werden können. Dies schließt jedoch nicht aus, dass das Gehäuseteil 112 ein anderes Rastermaß in Bezug auf die Länge, jedoch nicht hinsichtlich der Höhe im Vergleich zum Gehäuse 12 aufweist.

Wie zuvor erläutert, sind dem Gehäuse 12 und damit dem Wärmetauscher 32 zwei Ventilatoren 14, 16 zugeordnet. Entsprechend sind auch dem Gehäuseteil 112 unterhalb des Bodens 18 zwei Radialventilatoren 114 zugeordnet.

Sollen höhere Kühlleistungen erreicht werden, so können entsprechend zuvor erfolgter Erläuterungen weitere Gehäuseteile 112 aneinander gereiht werden, wobei zuvor der die Tür 29 aufnehmende erste Rahmen 35 der Stirnwandung 28 von dem Gehäuseteil 112 entfernt wird, um nach Ansetzen eines dem Gehäuseteil 112 entsprechenden Teils an dessen Stirnseite den die Stirnwandung begrenzenden ersten Rahmen 35 zu befestigen, von dem die Tür 29 ausgeht.

Erfindungsgemäß wird ein modulares System mit an einem Gehäuse aneinander reihbaren Gehäuseteil bzw. aneinander reihbaren Gehäuseteilen 112 zur Verfügung gestellt, um mit konstruktiv einfachen Maßnahmen eine gewünschte Kühlleistung in einem Raum zu erzielen. Dabei können das Gehäuse 12 bzw. das bzw. die aneinander gereihten Gehäuseteil(e) 112 - nachstehend vereinfacht insgesamt Gehäuse genannt - auch entlang einer Begrenzungswandung des zu kühlenden Raums angeordnet werden. Werden die Gehäuse unmittelbar an die Wand gestellt, so können die entlang dieser verlaufenden Seitenwandungen bzw. die Stirnwandung entfernt werden.

Die Tür ermöglicht, dass der Innenraum der Anordnung begehbar ist, so dass eine problemlose Wartung und auch Überprüfung hinsichtlich hygienischer Gegebenheiten erfolgen kann.

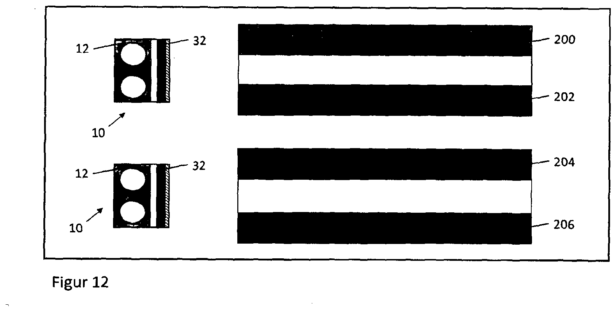

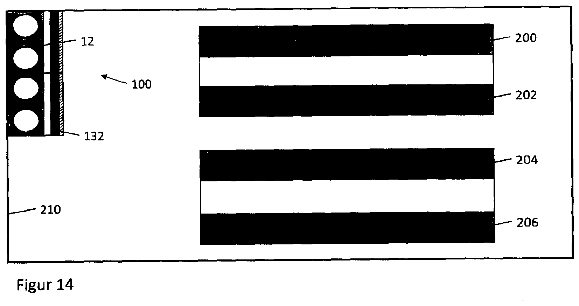

Anhand der Fig. 12 - 16 sind rein prinzipiell Aufstellungsmöglichkeiten der erfindungsgemäßen Anordnung wiedergeben, wobei die Anordnung aus einem Gehäuse oder einem Gehäuse 12 mit an diesem angesetzten Gehäuseteil 112 oder auch aus mehreren aneinandergereihten mit dem Gehäuse 12 verbundenen Gehäuseteilen 112 bestehen kann, wie dies zuvor erläutert worden ist. Dabei ist in der zeichnerischen Darstellung jeweils ein Raum in Draufsicht dargestellt, in dem in parallel zueinander verlaufenden Reihen in Racks, also Gestellen, wärmeerzeugende Geräte wie Server angeordnet sind. Die entsprechenden Reihen sind in den Figuren mit den Bezugszeichen 200, 202, 204, 206 gekennzeichnet.

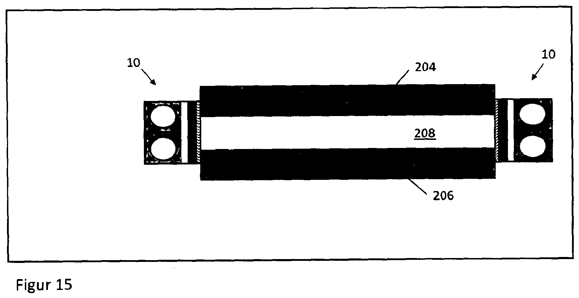

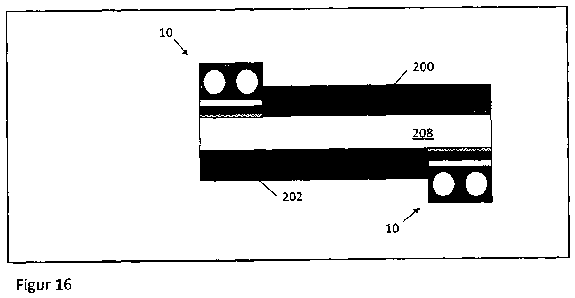

Zwei parallel zueinander verlaufende und einander zugeordnete Reihen 200, 202 bzw. 204, 206 können dabei einen Warmgang 208 begrenzen, wie dies anhand der Fig. 15 und 16 ersichtlich ist.

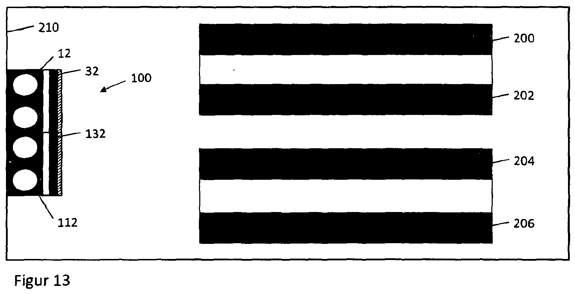

In Fig. 12, der - wie den Fig. 13 bis 16 - ein Grundriss des Raums zu entnehmen ist, der seinerseits von durch durchgezogene Linien symbolisierte Begrenzungen wie Wandungen umgeben ist, sind in dem Raum zwei erfindungsgemäße Anordnungen 10 angeordnet, über die von den in den Racks angeordneten Geräten abgegebene Wärme angesaugt, gekühlt und sodann über nicht eingezeichnete Öffnungen im Boden des Raums dem Bereich des Raums wieder zugeführt wird, in dem die Racks angeordnet sind. Dabei ist insbesondere vorgesehen, dass unmittelbar unterhalb der Racks Öffnungen vorhanden sind, wohingegen zwischen den Racks 200, 202 bzw. 204, 206 der Boden geschlossen sein sollte.

Die Anordnungen 10 weisen in zuvor beschriebener Weise ein Gehäuse 12 auf, dessen rackseitig verlaufende und als erste Stirnwandung bezeichnete Stirnwandung durch einen Wärmetauscher 32 ersetzt ist, der außenseitig ein Filter und sodann die Wärmetauscherfläche aufweist. Der Wärmetauscher 32 ist vorzugsweise ein LamellenWärmetauscher und wassergekühlt. Die offenen Kreise in den Gehäusen 12 verdeutlichen, dass diesen jeweils zwei Ventilatoren 12, 14 zugeordnet sind, die sich unterhalb der Gehäuse 12 in dem Hohlboden 20 befinden, der einerseits von dem Raumboden 18und andererseits von der Standfläche begrenzt ist, auf der die Gehäuse 12 sowie die Racks aufgestellt sind.

Das Ausführungsbeispiel der Fig. 13 unterscheidet sich von dem der Fig. 12 dahingehend, dass an einer Stirnwandung 210 des Raums eine Anordnung 100 positioniert ist. Dabei grenzen das Gehäuse 12 und das Gehäuseteil 112 unmittelbar an der Stirnwandung 210 an, so dass die den Wärmetauschern 32, 132 gegenüberliegende Rückseitenfläche entfernt sein kann.

Eine Positionierung der Anordnung 100 kann jedoch auch in einem Eckbereich eines Raums erfolgen. In diesem Fall kann die Rückseitenwandung der Anordnung 100 sowie die der Tür 29 gegenüberliegende Stirnwandung 26 des Gehäuses 12 entfernt sein, da die entsprechenden Flächen des Gehäuses 12 sowie des Gehäuseteils 112 von den Raumwänden abgedeckt werden.

Es besteht auch die Möglichkeit, Anordnungen 10 derart zu positionieren, dass diese den Warmgang 208 stirnseitig begrenzen, wie dies die Fig. 15 verdeutlicht.

Nach der Fig. 16 wird ein Bereich der in Reihen 200, 202 angeordneten Racks dahingehend verändert, dass wärmeerzeugende elektrische Geräte durch erfindungsgemäße Anordnungen 10 ersetzt werden. Eine diesbezügliche Positionierung kommt insbesondere dann in Frage, wenn ein Platzmangel herrscht.

Die Gehäuse können auf dem Boden 18, also dem zu dem Gehäuseboden beanstandeten Zwischenboden, aufgestellt werden, ohne dass zusätzliche Befestigungen erforderlich sind. Um ein Kippen der Gehäuse zu verhindern, können jedoch der bzw. die Wärmetauscher mit dem Boden und/oder einer weiteren Begrenzungswandung wie Deckenwandung des Raums verbunden werden.

Ist bevorzugterweise der jeweilige Wärmetauscher 32, 132 in den die offene Seitenwandung des Gehäuses begrenzenden Rahmen hineinschiebbar und gegenüber diesem z.B. über eine Moosgummidichtung abdichtbar, so können die Wärmetauscher selbstverständlich auch auf Stoß mit den entsprechenden Schenkeln des zuvor als fünften Rahmen bezeichneten Rahmens verbunden werden.

Des Weiteren sollten die Wärmetauscher 32, 132 in gewohnter Weise lufteintrittsseitig ein Filter aufweisen, das seinerseits von einer perforierten Abdeckung wie einem Lochblech abgedeckt sein kann.

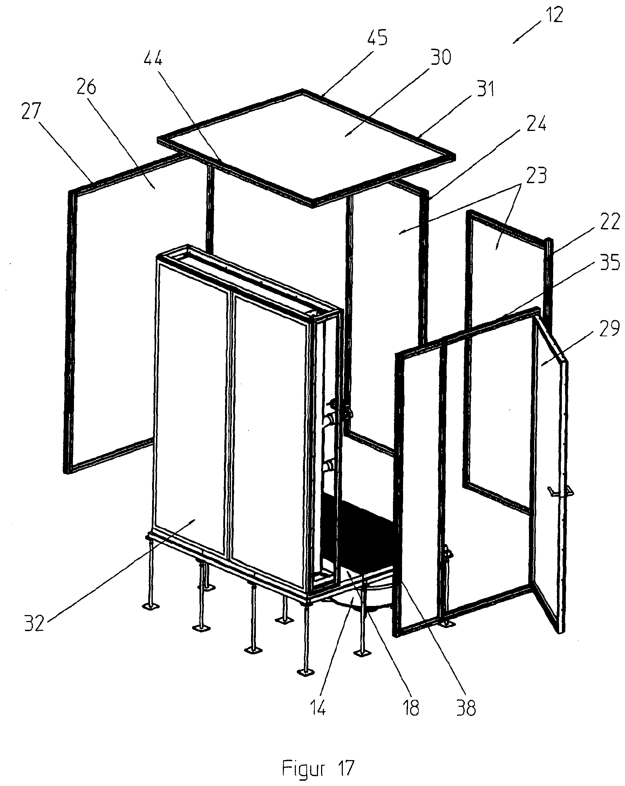

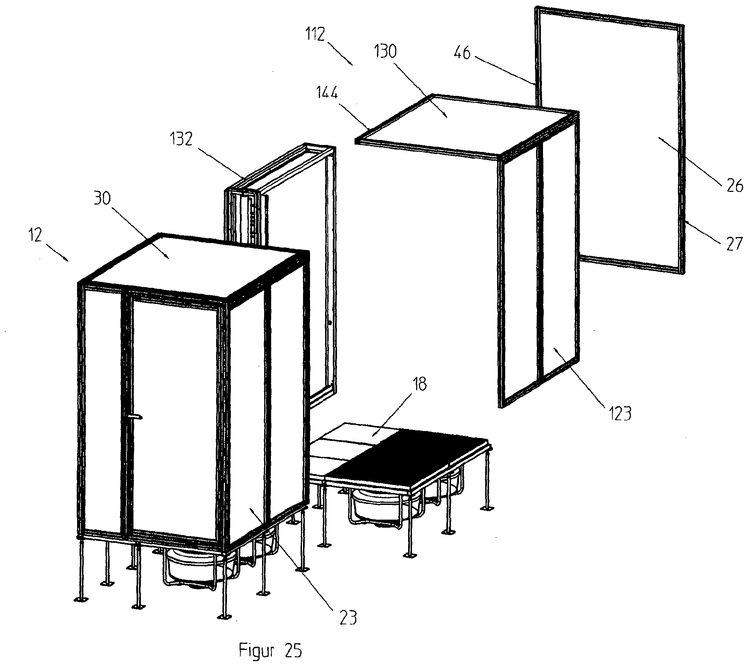

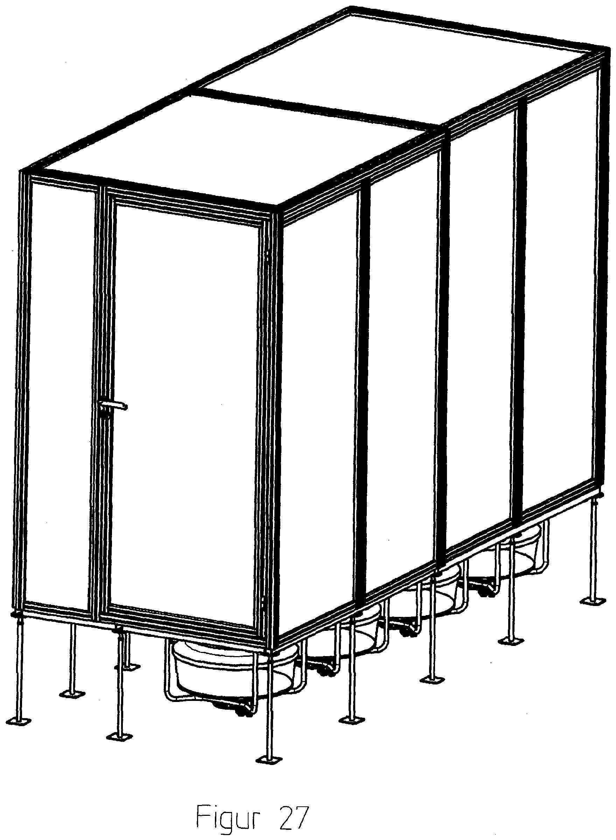

Den Fig. 17 bis 27 sind noch einmal klar erkennbar und selbsterklärend die wesentlichen Merkmale zu entnehmen, die die Erfindung auszeichnen. Dabei unterscheiden sich die den Fig. 17 bis 27 zu entnehmenden Ausführungsformen im Wesentlichen von denen der Fig. 1 bis 11 dahingehend, dass Frontfläche des Wärmetauschers bzw. die diese raumseitig verschließende Abdeckung fluchtend zur Außenseite des fünften Rahmens verläuft, der den Wärmetauscher aufnimmt. Auch ist vorgesehen, dass zur Erweiterung der Anordnung nicht der erste Rahmen 35 mit der Tür 29 entfernt wird, um ein oder mehrere Gehäuseteile 112 einzusetzen, um also das Klimatisierungsgerät aufzuskalieren, sondern die gegenüberliegende Stirnwandung 26 mit dem dritten Rahmen 27.

Des Weiteren ist darauf hinzuweisen, dass die Erfindung auch den Gedanken umfasst, dass ein nicht modular aufgebautes Gehäuse entsprechend der erfindungsgemäßen Lehre durch Gehäuseteile 112 erweitert werden kann. Hierzu ist es nur erforderlich, dass entweder die die Tür aufweisende Stirnwandung oder die gegenüber liegende Stirnwandung entfernt wird, um entsprechend zuvor erläuterter Verfahrensweise Gehäuseteile und Wärmetauscher einzusetzen, um die Kühlleistung zu erhöhen.

Anhand der Fig. 17 wird noch einmal deutlich, dass sowohl das Gehäuse 12 als auch die Anordnung an sich modular aufgebaut sind. Dabei ist das Gehäuse 12 auf einem Bereich des aufgeständerten Bodens 18 angeordnet, der Durchbrechungen aufweist, die eine Verbindung zwischen dem Innenraum des Gehäuses 12 und der Ansaugseite des mit dem aufgeständerten Boden 18 verbundenen Ventilators 14 ermöglicht. Insbesondere sind - wie zuvor erläutert - zwei Ventilatoren 14, 16 dem Gehäuse 12 zugeordnet.

In der Darstellung der Fig. 17 ist mit dem Boden 18 zunächst der Wärmetauscher 32 befestigt worden, um sodann den ersten Rahmen 35, der die Tür 29 aufweist, die aus den Abschottelementen 22, 24 bestehende und den zuvor als vierten Rahmen bezeichneten Rahmen 49 bildende Rückseitenwandung 23, die dem ersten Rahmen 35 gegenüber liegende und den dritten Rahmen 27 zur Verfügung stellende Stirnwandung 26 sowie die Kopfwandung 30, die von dem zweiten Rahmen 31 umgeben ist, miteinander zu verbinden. Zuvor sind die Ventilatoren 14, 16 über nicht näher bezeichnete Halterungen mit dem aufgeständerten Boden 18 verbunden.

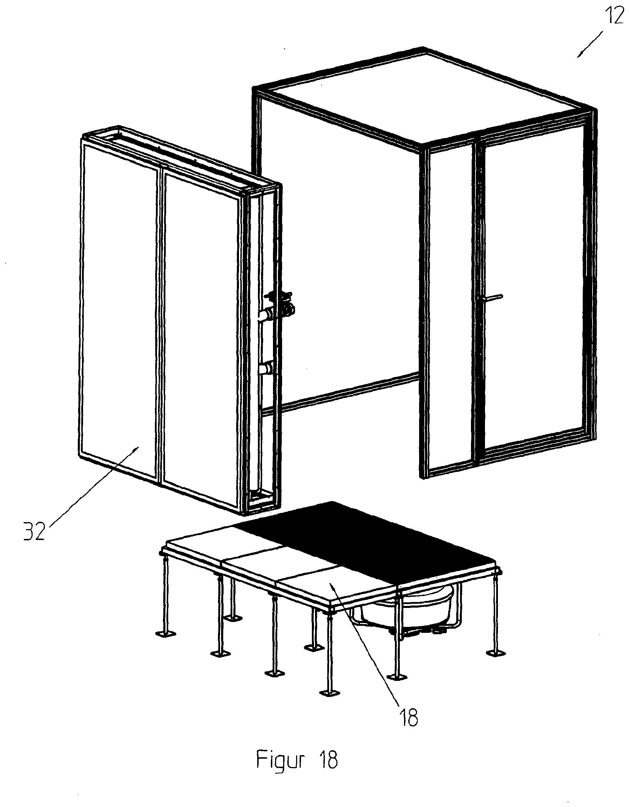

Anhand der Fig. 18 soll verdeutlicht werden, dass die das Gehäuse 12 bildenden Wandungen bzw. Rahmen zunächst zusammengesetzt werden, um sodann als Einheit mit dem Boden 18 verbunden zu werden. Anschließend wird der Wärmetauscher in den von den Längs- bzw. Querschenkeln 38, 46, 44 der Stirnwandungen 26, 28 und der Kopfwandung 30 gebildeten fünften Rahmen 37 hineingeschoben und mit diesem verbunden. Gleichzeitig wird eine Abdichtung gegenüber dem Innenraum des Gehäuses 12 hergestellt.

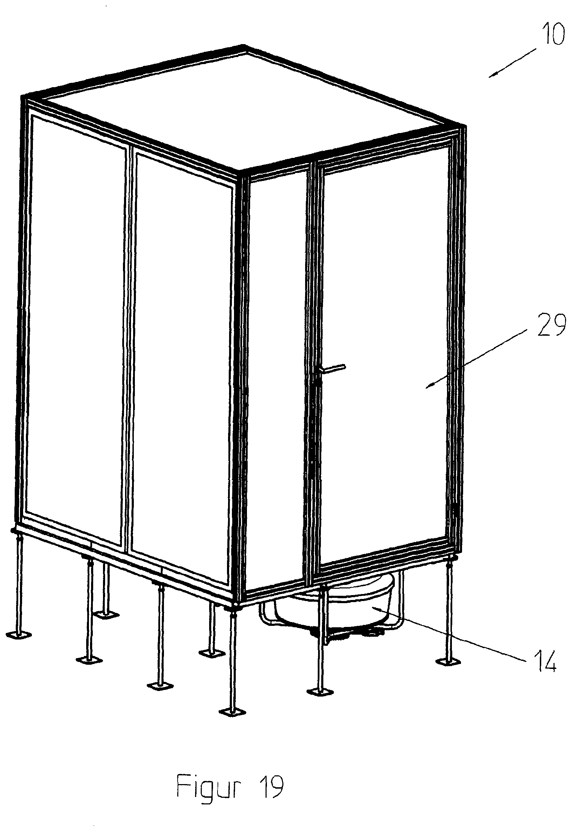

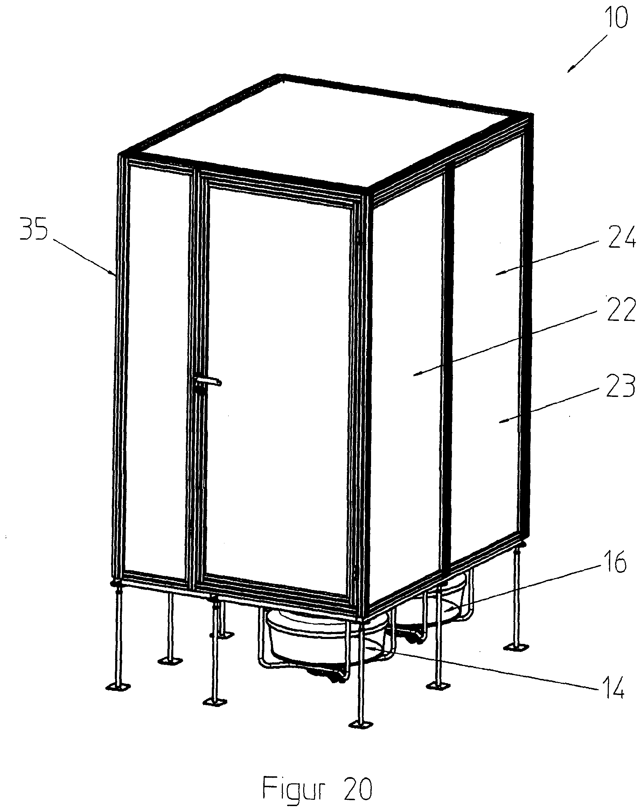

In Fig. 19 ist eine zusammengesetzte Anordnung 10 - in Richtung der Tür 29 betrachtet - dargestellt. In Fig. 20 ist die Anordnung 10 in Richtung der Seitenwandung 23 betrachtet, die im Ausführungsbeispiel durch die Abschottelemente 22, 24 gebildet wird, wiedergegeben. In diesem Zusammenhang ist anzumerken, dass die Seitenwandung 23 einstückig ausgebildet sein oder aus mehr als zwei Abschottelementen bestehen kann.

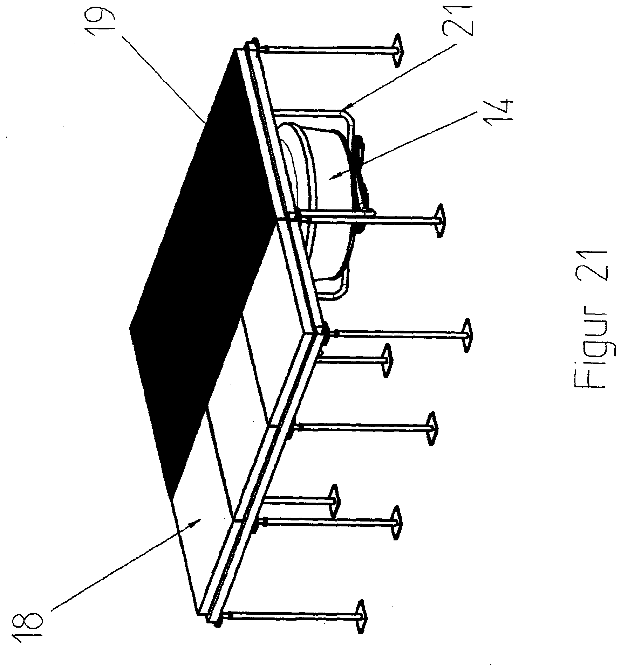

Der Fig. 21 ist noch einmal ein Abschnitt eines aufgeständerten Bodens 18 mit einem Bereich 19 dargestellt, der Durchbrechungen aufweist und unter dem die Ventilatoren 14, 16 befestigt sind. Entsprechende Halterungen 21 können mit der Unterseite des Bodens 18 verbunden sein.

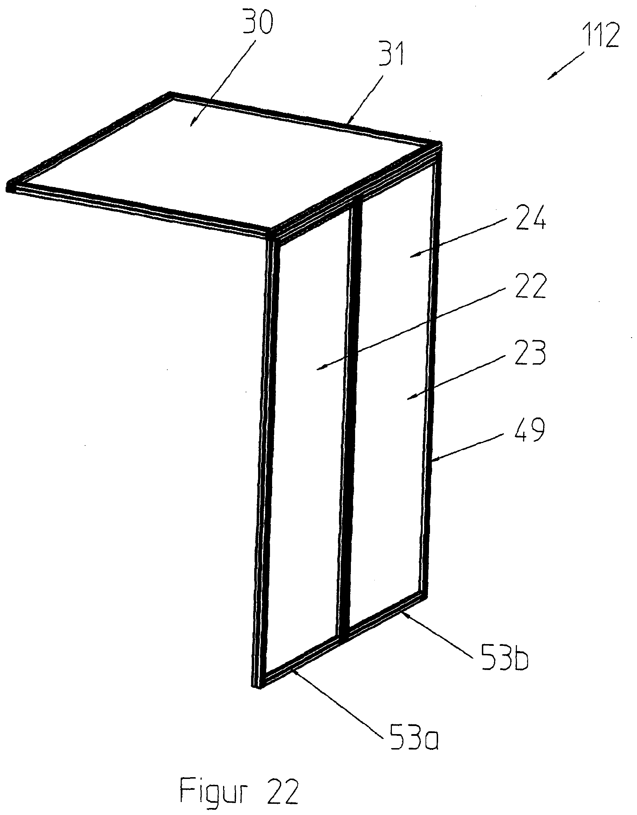

Die Fig. 22 entspricht in anderer Ansicht der Fig. 12 und gibt ein Gehäuseteil 112 wieder, das zur Erweiterung der Kühlleistung einer erfindungsgemäßen Anordnung das Gehäuse 12 vergrößert, in dem entweder der die Tür 29 aufweisende erste Rahmen 35 oder der gegenüber liegende als dritter Rahmen bezeichnete Rahmen 27 der Stirnwandung 26 entfernt wird, um das Gehäuseteil 112 einzusetzen.

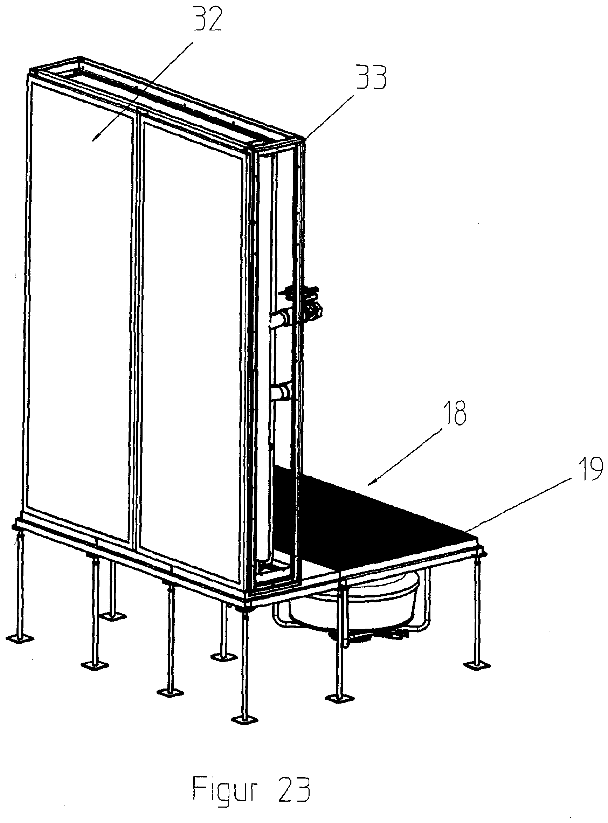

In Fig. 23 ist noch einmal ein Wärmetauscher 32 dargestellt, der auf dem aufgeständerten Boden 18 aufgesetzt ist. Man erkennt den umlaufenden Rahmen 33, der mit dem fünften Rahmen 37 verbunden und gegenüber diesem abgedichtet wird.

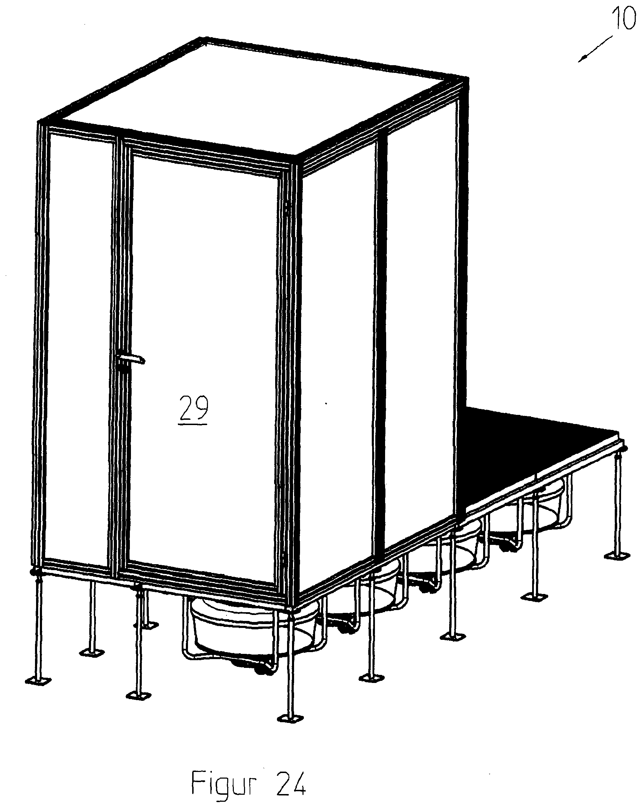

Anhand der Fig. 24 bis 26 soll noch einmal verdeutlicht werden, wie eine erfindungsgemäße Anordnung erweitert werden kann. So ist in Fig. 24 ein erfindungsgemäßes Gehäuse 10 dargestellt. Um die Kühlleistung zu vergrößern, wird im Ausführungsbeispiel die der Tür 29 gegenüber liegende Stirnwandung 26 mit ihrem als dritten Rahmen bezeichneten Rahmen 27 entfernt. Sodann wird auf dem Hohlboden 18 fluchtend zur Rückseitenwandung 23 die Rückseitenwandung 123 des Gehäuseteils 112 auf dem aufgeständerten Boden 18 positioniert. Von der Rückseitenwandung 123 geht im rechten Winkel abragend die Kopfwandung 130 aus und verläuft in positionierter Stellung fluchtend zur Kopfwandung 30 des (Rest-) Gehäuses 12. Sodann wird an den freien Schenkeln der Rückseitenwandung 123 und der Kopfwandung 130 erneut die rückseitige Stirnwandung 26 befestigt. In den von dem Querschenkel 144 des Kopfteils 130 und dem Längsschenkel 46 der Rückseitenwandung 26 gebildeten Teilrahmen wird sodann der weitere Wärmetauscher 132 hineingeschoben, der zu dem bereits in dem Gehäuse 12 vorhandenen Wärmetauscher 32 fluchtend ausgerichtet und gegenüber diesem abgedichtet wird.

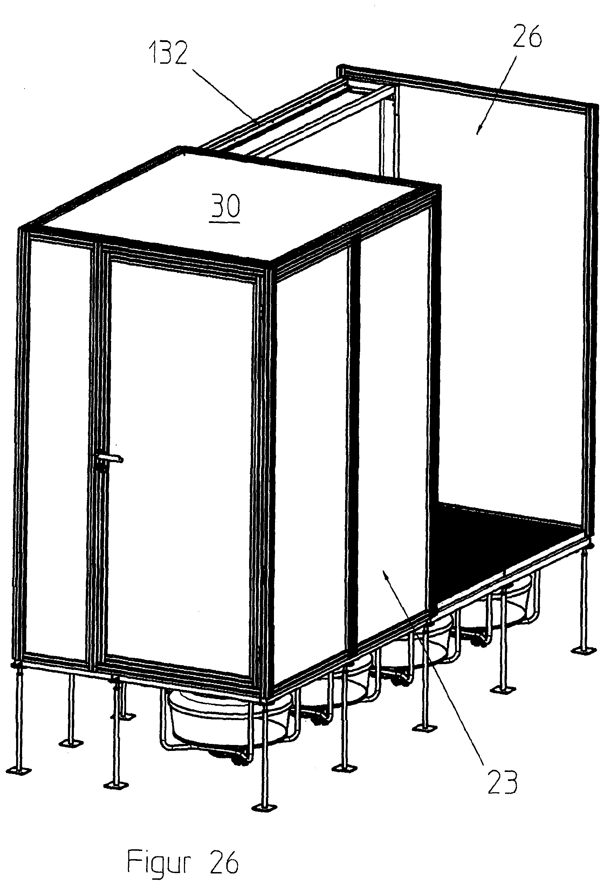

Entsprechend der zeichnerischen Darstellung der Fig. 26 besteht selbstverständlich auch die Möglichkeit, dass zunächst der Wärmetauscher 132 positioniert und die Rückseitenwandung 26 befestigt wird, um anschließend das Gehäuseteil 112 einzusetzen und mit der rückseitigen Stirnwandung 26 und dem Gehäuse 12 bzw. den Schenkeln der Rückseitenwandung 23 und der Kopfwandung 30 zu verbinden.

Typische Abmessungen des Gehäuses bzw. der Gehäuseteile sind Folgende:
1800 mm Breite x 2400 mm Höhe x 1500 mm Tiefe.

Die Rahmenschenkel sollten insbesondere aus Aluminium oder Stahl bestehen.

Bei den Wärmetauschern handelt es sich insbesondere um wassergekühlte LamellenWärmetauscher, wobei als Fabrikat z. B. in Frage kommt: Luvata, Seveso.
- 10, 100: Anordnung
- 12, 112: Gehäuse
- 14, 114: Ventilator
- 16, 116: Ventilator
- 18: Boden
- 19: Durchbrechungen
- 20: Zwischenboden
- 22, 122: Abschottelement
- 23, 123: Rückseitenwandung
- 24, 124: Abschottelement
- 26: Stirnwandung
- 27: 3. Rahmen (Stirnwandung 26)
- 28: Wandung
- 29: Tür
- 30, 130: Kopfwandung
- 31: 2. Rahmen (Kopfwandung 30)
- 32, 132: Wärmetauscher
- 33: Rahmen (Wärmetauscher 32)
- 34: Längs schenkel
- 35: 1. Rahmen (Wandung 28)
- 36: Querschenkel
- 37: 5. Rahmen (Wärmetauscher 32)
- 38: Längs schenkel
- 40, 140: Längs schenkel
- 42, 142: Querschenkel
- 43: Querschenkel
- 44: Schenkel
- 45: Längs schenkel
- 46: Längs schenkel
- 47a, 47b: Querschenkel
- 49: 4. Rahmen (Rückseitenwandung 23)
- 51: Schenkel
- 53: Schenkel
- 53a, 53b: Schenkel
- 55: Querschenkel
- 57: Schenkel
- 59: Schenkel
- 200: Reihen
- 202: Reihen
- 204: Reihen
- 206: Reihen
- 208: Warmgang
- 210: Stirnwandung

## Patentansprüche

1. Modulare Anordnung (10, 100) zum Kühlen eines Raums, dessen Durchtrittsöffnungen aufweisender Boden (18) einen Hohlraum (20) begrenzt, mit zumindest einem auf dem Boden aufgestellten quaderförmigen Gehäuse (12), von dem zumindest eine erste Seitenwandung zumindest abschnittsweise, vorzugsweise vollständig, als Wärmetauscherfläche eines ersten Wärmetauschers und eine zweite Seitenwandung als Tür (29) ausgebildet ist oder eine solche aufweist, sowie zumindest einem Ventilator (14, 16, 114), der im Hohlraum angeordnet ist, wobei der Ventilator strömungsmäßig mit Innenraum des Gehäuses (12) verbunden ist,
**dadurch gekennzeichnet,**
**dass** die Anordnung (10, 100) modular aufgebaut ist mit dem die Wärmetauscherfläche bildenden zumindest einen ersten Wärmetauscher (32, 132) als erstes Modulteil, dem Gehäuse (12) als zweites Modulteil und dem zumindest einen Ventilator (14, 16, 114) als drittes Modulteil, wobei das Gehäuse oder Teile des Gehäuses zur Vergrößerung der Wärmetauscherfläche für zumindest ein weiteres an dieses anreihbares Gehäuse oder anreihbare Gehäuseteile nutzbar ist bzw. sind.

2. Anordnung (10, 100) zum Kühlen eines Raums, dessen Durchtrittsöffnungen aufweisender Boden (18) einen Hohlraum (20) begrenzt, umfassend
- zumindest einen eine Wärmetauscherfläche zur Verfügung stellenden ersten Wärmetauscher (32),
- ein auf dem Boden aufgestelltes Gehäuse (12) quaderförmiger Geometrie mit einer ersten Seitenwandung, die zumindest abschnittsweise, vorzugsweise vollständig, mit dem zumindest einen ersten Wärmetauscher (32) bzw. dessen Wärmetauscherfläche verschlossen ist, eine senkrecht zu der ersten Seitenwandung verlaufenden zweiten Seitenwandung (26) mit einer Tür (29) sowie der ersten Seitenwandung gegenüberliegenden dritten Seitenwandung als Rückseitenwandung (23), der zweiten Seitenwandung gegenüberliegender vierten Seitenwandung (26) sowie die Seitenwandungen kopfseitig begrenzender Kopfwandung (30),
- zumindest einen in dem Hohlraum (20) angeordneten Ventilator (14, 16, 114), der strömungsmäßig mit Innenraum des Gehäuses (12) verbunden ist,
**dadurch gekennzeichnet,**
**dass** die Anordnung (10, 100) modular aufgebaut ist mit
- dem zumindest einen ersten Wärmetauscher (32) als erstes Modulteil,
- dem Gehäuse (12) als zweites Modulteil,
- dem zumindest einen Ventilator (14, 16) als drittes Modulteil,
wobei der zumindest eine erste Wärmetauscher von einem die erste Seitenwandung begrenzenden Rahmen oder Abschnitte eines solchen aufgenommen ist, die Tür (29) mit einem die zweite Seitenwandung (28) begrenzenden oder aufweisenden ersten Rahmen (35) verbunden ist, der einen Längsrahmenschenkel (38) aufweist, der in einer Ebenen verläuft, die von der ersten Seitenwandung aufgespannt ist, wobei zur Erweiterung der Kühlleistung der Anordnung zwischen dem ersten Rahmen (35) mit der Tür (29) zumindest ein Gehäuseteil (112) als viertes Modulteil eingesetzt ist, das aus einem bündig in die Kopfwandung (30) übergehenden Kopfteil (130) und einem bündig in die Rückseitenwandung (23) übergehenden Rückseitenteil (123) besteht, und wobei zwischen dem ersten Längsrahmenschenkel (38) und dem zumindest einen ersten Wärmetauscher (32) ein zweiter Wärmetauscher (132) angeordnet ist.

3. Anordnung nach Anspruch 2,
**dadurch gekennzeichnet,**
**dass** zwischen Restgehäuse (12) und dem ersten Rahmen (35) mehrere Gehäuseteile (112) mit jeweils einem Wärmetauscher (132) angeordnet sind, wobei die Wärmetauscher mit ihren Wärmetauscherflächen fluchtend angeordnet sind und eine im Wesentlichen geschlossene Fläche bilden.

4. Anordnung nach Anspruch 2 oder 3,
**dadurch gekennzeichnet,**
**dass** zur Erweiterung der Kühlleistung der Anordnung (100) anstelle zwischen dem ersten Rahmen (35) und verbleibendem Restgehäuse zwischen der der zweiten Seitenwandung gegenüber liegenden vierten Seitenwandung (26) und dem verbleibenden Restgehäuse ein viertes Modulteil (112) oder mehrere vierte Modulteile eingesetzt sind.

5. Anordnung (10, 100) nach Anspruch 1,
**dadurch gekennzeichnet,**
**dass** das Gehäuse (12) eine Quaderform mit die Wandungen begrenzenden Rahmen aufweist und/oder
**dass** das Gehäuse modular derart aufgebaut ist, dass die Tür (29) von einem ersten Rahmen (35) aufgenommen ist, dass der erste Rahmen und/oder ein dem ersten Rahmen gegenüber liegende die der Tür gegenüber liegende Seitenwandung (27) aufspannender dritter Rahmen (27) von dem Gehäuse (10) lösbar ist, und dass mit verbleibendem Gehäuseteil ein weiteres Gehäuseteil (112) verbindbar ist, wobei der erste und/oder dritte Rahmen eine Wandung wie Seitenwandung des weiteren Gehäuseteils (112) bildet, und wobei vorzugsweise die die Tür (29) aufweisende Wandung senkrecht zu dem Wärmetauscher bzw. den Wärmetauschern (32, 132) verläuft.

6. Anordnung (10, 100) nach zumindest einem der vorherigen Ansprüche,
**dadurch gekennzeichnet,**
**dass** von dem Gehäuse (12) und zumindest einem mit diesem verbundenen Gehäuseteil (112) ineinander übergehende erste Seitenwandungen als Wärmetauscherflächen ausgebildet sind, wobei die Wärmetauscherflächen bildende Wärmetauscher (32, 132) insbesondere auf Stoß aneinandergrenzen.

7. Anordnung (10, 100) nach zumindest einem der vorherigen Ansprüche,
**dadurch gekennzeichnet,**
**dass** das Gehäuse (12) mit einem oder mehreren weiteren Gehäuseteilen (112) aneinandergereiht eine Gehäuseeinheit bildet, von der eine Längsseitenfläche als Wärmetauscherfläche ausgebildet ist.

8. Anordnung (10, 100) nach zumindest einem der vorherigen Ansprüche,
**dadurch gekennzeichnet,**
**dass** der dem Gehäuse (12) zugeordnete zumindest eine Ventilator (14, 16) in Projektion des Gehäuses in Richtung des Bodens (18) unterhalb von dem Gehäuse angeordnet ist und mit dem Boden verbunden und/oder auf Bodenfläche des Hohlraums (20) aufgeständert ist.

9. Anordnung (10, 100) nach zumindest einem der vorherigen Ansprüche,
**dadurch gekennzeichnet,**
**dass** dem Gehäuseteil (112) zumindest ein Ventilator (116), vorzugsweise eine dem Gehäuse (12) zugeordnete Anzahl von Ventilatoren (14, 16) zugeordnet ist, wobei vorzugsweise dem Gehäuse (12) zwei Ventilatoren zugeordnet sind, dessen Saugseiten innerhalb von dem Gehäuse (12) umgebener Fläche des Bodens (18) verlaufen.

10. Anordnung (10, 100) nach zumindest einem der vorherigen Ansprüche,
**dadurch gekennzeichnet,**
**dass** der Wärmetauscher (32, 132) auf Stoß mit einem die Seitenwandung umgebenden zweiten Rahmen (37) verbunden ist oder umfangsseitig von dem zweiten Rahmen umgeben ist und vorzugsweise gegenüber diesem z.B. mittels einer Moosgummidichtung abgedichtet ist, und/oder dass der Wärmetauscher (32, 132) gehäuseaußenseitig mit einer perforierten Abdeckung wie einem Lochblech versehen ist.

11. Anordnung (10, 100) nach zumindest einem der vorherigen Ansprüche,
**dadurch gekennzeichnet,**
**dass** der Boden (18) zumindest unmittelbar unterhalb des Gehäuses (12) bzw. Gehäuseteils (112) auf der Bodenfläche des Hohlraums (20) aufgeständert ist und dass in diesem Bereich der zumindest eine Ventilator (14, 16, 114) mit dem Boden (18) verbunden ist.

12. Anordnung (10, 100) nach zumindest einem der vorherigen Ansprüche,
**dadurch gekennzeichnet,**
**dass** die Anordnung (100) aus einem Gehäuse und zumindest einem weiteren Gehäuseteil (12, 112) besteht, dass die Anordnung begehbar ist, dass eine Längsseite der Anordnung als Wärmetauscherfläche ausgebildet ist, die durch auf Stoß ineinander übergehende Wärmetauscher (32, 132) gebildet ist, dass eine Stirnwandung der Anordnung zumindest bereichsweise als Tür (29) ausgebildet ist, die von dem ersten Rahmen (35) aufgenommen ist, der mit zugeordneten stirnseitigen Rahmenschenkeln (40, 42, 140, 142) des zu verschließenden Gehäuses bzw. Gehäuseteils verbunden ist, und dass dem Gehäuse und jedem Gehäuseteil zumindest ein mit dem das Gehäuse und das zumindest eine Gehäuseteil abstützenden Bodenbereich des Bodens (18) verbundener Radialventilator (14, 16,114) zugeordnet ist.

13. Anordnung (10, 100) nach zumindest einem der vorherigen Ansprüche,
**dadurch gekennzeichnet,**
**dass** das Gehäuse (12), vorzugsweise das Gehäuse mit zumindest einem mit diesem verbundenen Gehäuseteil (112), unmittelbar an einer Innenwandung des Raums angrenzt, wobei die entlang der zumindest einen Innenwandung verlaufende Wandung des Gehäuses bzw. des Gehäuseteils entfernt ist, und/oder dass das Gehäuse (12) bzw. eine aus dem Gehäuse und zumindest einem Gehäuseteil bestehende Einheit befestigungslos auf dem Boden (18) aufsteht.

14. Anordnung (10, 100) nach zumindest einem der vorherigen Ansprüche,
**dadurch gekennzeichnet,**
**dass** der Wärmetauscher (32, 132) mit einer Raumbegrenzung verbunden ist oder dass der Wärmetauscher (32, 132) von einem Rahmen umgeben ist, der gegenüber dem von dem Gehäuse (12) bzw. Gehäuse und zumindest einem Gehäuseteil (112) gebildeten zweiten Rahmen (37) und einem gegebenenfalls vorhandenen weiteren Wärmetauscher abgedichtet ist.

15. Anordnung (10, 100) nach zumindest einem der vorherigen Ansprüche,
**dadurch gekennzeichnet,**
**dass** die aus dem Gehäuse (12) und zumindest einem Gehäuseteil (112) bestehende Anordnung (10, 110) aus einer geschlossenen Kopfwandung, einer geschlossenen ersten Stirnwandung (26) und einer geschlossenen Seitenwandung (23) besteht, dass die der Seitenwandung (23) gegenüberliegende erste Seitenwandung durch zumindest einen Wärmetauscher (32, 132) gebildet ist und dass die der ersten Stirnwandung gegenüberliegende Stirnwandung eine Tür (29) aufweist.

16. Anordnung (10, 100) nach zumindest einem der vorherigen Ansprüche,
**dadurch gekennzeichnet,**
**dass** in dem zu kühlenden Raum in Reihen (200, 202, 204, 206) angeordnete Wärme erzeugende Geräte in Gestellen angeordnet sind, wobei ein Gestell oder ein Abschnitt von diesem durch das Gehäuse (12) oder durch das Gehäuse und zumindest ein mit diesem verbundenes Gehäuseteil (112) ersetzt ist.

17. Verfahren zum Kühlen eines Raums mit einem Durchtrittsöffnungen aufweisenden einen Hohlraum (20) begrenzenden Boden (18), **gekennzeichnet durch** die Verfahrensschritte
- Anordnen einer modular aufgebauten Anordnung (10, 100) in dem Raum, umfassend ein quaderförmiges Gehäuse (12) mit einer als Wärmetauscherfläche zumindest eines ersten Wärmetauschers (32) ausgebildeten ersten Seitenwandung, einer senkrecht zu dieser verlaufenden von einem ersten Rahmen (35) begrenzten zweiten Seitenwandung (28) mit einer Tür (29), wobei der erste Rahmen einen Längsschenkel (38) aufweist, der in einer Ebene verläuft, die von der ersten Seitenwandung aufgespannt wird, einer der ersten Seitenwandung gegenüberliegenden dritten Seitenwandung als Rückseitenwandung (23), einer der zweiten Seitenwandung gegenüberliegenden vierten Seitenwandung (26) mit einem diese aufspannenden dritten Rahmen (27) mit Längsschenkel (46), der in der Ebene verläuft, die von der ersten Seitenwandung aufgespannt wird, einer die Seitenwandungen kopfseitig begrenzenden Kopfwandung sowie zumindest einen unterhalb des Gehäuses in dem Hohlraum (20) angeordneten und strömungsmäßig mit dessen Innenraum verbundenen Ventilator (14, 16),
wobei das Gehäuse ein erstes Modulteil, der zumindest eine erste Wärmetauscher ein zweites Modulteil und der zumindest eine Ventilator ein drittes Modulteil bilden,
- wobei zur Erweiterung der Kühlleistung der erste und/oder dritte Rahmen entfernt wird, mit dem verbleibenden Restgehäuse ein weiteres Gehäuseteil (112) als viertes Modulteil verbunden wird, das ein mit der Kopfwandung des Restgehäuses zu verbindendes Kopfteil (130) und ein mit der Rückseitenwandung des Restgehäuses zu verbindendes Rückenteil (123) aufweist,
- der erste und/oder dritte Rahmen mit dem weiteren Gehäuseteil (112) verbunden wird und
- in den von dem Längsschenkel des ersten und/oder dritten Rahmens, dem Kopfteil (130) des eingesetzten Gehäuseteils (112) sowie dem im Restgehäuse vorhandenen zumindest einen ersten Wärmetauscher umgebenen Freiraum ein weiterer Wärmetauscher eingesetzt wird, dessen Wärmetauscherfläche auf die des ersten Wärmetauschers ausgerichtet wird.

18. Verfahren nach Anspruch 17,
**dadurch gekennzeichnet,**
**dass** zwischen dem ersten und/oder dritten Rahmen (35, 27) und dem verbleibenden Restgehäuse mehrere entsprechende Gehäuseteile (112) und entsprechende Wärmetauscher (32, 132) angeordnet werden.

## Claims

1. Modular arrangement (10, 100) for cooling a room whose floor (18) having passage openings limits a cavity (20), with at least one cuboid housing (12) set up on the floor and whose at least one first side wall is designed at least in some sections and preferably completely as a heat exchanger surface of a first heat exchanger, and a second side wall is designed as or has a door (29), and with at least one fan (14, 16, 114) arranged in the cavity and flow-connected to the interior of the housing (12),
wherein
the arrangement (10, 100) has a modular structure with the at least one first heat exchanger (32, 132) forming the heat exchanger surface as a first module part, with the housing (12) as a second module part, and with the at least one fan (14, 16, 114) as a third module part, the housing or parts thereof being usable for enlarging the heat exchanger surface for at least one further housing arrangeable in a row thereto or for housing parts arrangeable in a row.

2. Arrangement (10, 100) for cooling a room whose floor (18) having passage openings limits a cavity (20), comprising
- at least one first heat exchanger (32) providing a heat exchanger surface,
- a housing (12) of cuboid geometry set up on the floor with a first side wall which is closed at least in some sections and preferably completely by the at least one first heat exchanger (32) or its heat exchanger surface, a second side wall (26) vertical to the first side wall and with a door (29), a third side wall opposite the first side wall as a rear side wall (23), a fourth side wall (26) opposite the second side wall, and a top wall (30) limiting the side walls at the top,
- at least one fan (14, 16, 114) arranged in the cavity (20) and flow-connected to the interior of the housing (12),
wherein
the arrangement (10, 100) has a modular structure with
- the at least one first heat exchanger (32) as a first module part,
- the housing (12) as a second module part,
- the at least one fan (14, 16) as a third module part,
where the at least one first heat exchanger is held by a frame or sections thereof limiting the first side wall, the door (29) is connected to a first frame (35) limiting or having the second side wall (28) and having a longitudinal frame piece (38) extending in a plane formed by the first side wall, where to increase the cooling capacity of the arrangement at least one housing part (112) is inserted as a fourth module part between the first frame (35) with the door (29) and consists of a top part (130) fitting flush into the top wall (30) and of a rear side part (123) fitting flush into the rear side wall (23), and where a second heat exchanger (132) is arranged between the first longitudinal frame piece (38) and the at least one first heat exchanger (32).

3. Arrangement according to claim 2,
**wherein**
several housing parts (112) each with one heat exchanger (132) are arranged between the remaining housing (12) and the first frame (35), where the heat exchangers are arranged such that their heat exchanger surfaces are aligned and form a substantially closed surface.

4. Arrangement according to claim 2 or 3,
**wherein**
to increase the cooling capacity of the arrangement (100) a fourth module part (112) or several fourth module parts is/are inserted between the fourth side wall (26) opposite the second side wall and the remaining housing instead of between the first frame (35) and the remaining housing.

5. Arrangement (10, 100) according to claim 1,
**wherein**
the housing (12) has a cuboid form with a frame defining the walls and/or
the housing has a modular structure such that the door (29) is held by a first frame (35), the first frame and/or a third frame (27) opposite the first frame and forming the side wall (27) opposite the door is/are detachable from the housing (10), and a further housing part (112) is connectable to the remaining housing part, where the first and/or third frame(s) form(s) a wall such as a side wall of the further housing part (112), and where the wall having the door (29) preferably runs vertical to the heat exchanger(s) (32, 132).

6. Arrangement (10, 100) according to at least one of the preceding claims,
**wherein**
first side walls fitting into one another of the housing (12) and of at least one housing part (112) connected thereto are designed as heat exchanger surfaces, where the heat exchangers (32, 132) forming heat exchanger surfaces adjoin one another in particular in abutting manner.

7. Arrangement (10, 100) according to at least one of the preceding claims,
**wherein**
the housing (12) forms with one or more further housing parts (112) arranged in a row a housing unit of which one longitudinal side surface is designed as a heat exchanger surface.

8. Arrangement (10, 100) according to at least one of the preceding claims,
**wherein**
the at least one fan (14, 16) assigned to the housing (12) is, in a projection of the housing in the direction of the floor (18), arranged underneath the housing and is connected to the floor and/or supported on the floor surface of the cavity (20).

9. Arrangement (10, 100) according to at least one of the preceding claims,
**wherein**
at least one fan (116) is assigned to the housing part (112), preferably a number of fans (14, 16) are assigned to the housing (12), where preferably two fans are assigned to the housing (12) whose intake sides are inside the surface of the floor (18) surrounded by the housing (12).

10. Arrangement (10, 100) according to at least one of the preceding claims,
**wherein**
the heat exchanger (32, 132) is connected in abutting manner to a second frame (37) surrounding the side wall or is surrounded on the circumferential side by the second frame and is preferably sealed therefrom for example by means of a foam rubber seal, and/or
the heat exchanger (32, 132) is provided on the outside of the housing with a perforated cover such as a perforated metal sheet.

11. Arrangement (10, 100) according to at least one of the preceding claims,
**wherein**
the floor (18) is supported at least directly underneath the housing (12) or housing part (112) on the floor surface of the cavity (20) and in this area the at least one fan (14, 16, 114) is connected to the floor (18).

12. Arrangement (10, 100) according to at least one of the preceding claims,
**wherein**
the arrangement (100) consists of a housing and at least one further housing part (12, 112), the arrangement can be walked on, a longitudinal side of the arrangement is designed as a heat exchanger surface which is formed by heat exchangers (32, 132) fitting into one another in abutting manner, an end wall of the arrangement is designed at least in some areas as a door (29) held by the first frame (35) which is connected to assigned front frame pieces (40, 42, 140, 142) of the housing or housing parts to be closed, and at least one radial fan (14, 16, 114) connected to that floor area of the floor (18) supporting the housing and the at least one housing part is assigned to the housing and each housing part.

13. Arrangement (10, 100) according to at least one of the preceding claims,
**wherein**
the housing (12), preferably the housing with at least one housing part (112) connected thereto, directly adjoins an inner wall of the room, where the wall of the housing and/or of the housing part extending along the at least one inner wall is removed, and/or the housing (12) or a unit consisting of the housing and at least one housing part stands unfastened on the floor (18).

14. Arrangement (10, 100) according to at least one of the preceding claims,
**wherein**
the heat exchanger (32, 132) is connected to a room limiter, or the heat exchanger (32, 132) is surrounded by a frame which is sealed from the second frame (37) formed by the housing (12) or by said housing and at least one housing part (112) and from a further heat exchanger possibly provided.

15. Arrangement (10, 100) according to at least one of the preceding claims,
**wherein**
the arrangement (10, 110) consisting of the housing (12) and at least one housing part (112) consists of a closed top wall, a closed first end wall (26) and a closed side wall (23), the first side wall opposite the side wall (23) is formed by at least one heat exchanger (32, 132), and the end wall opposite the first end wall has a door (29).

16. Arrangement (10, 100) according to at least one of the preceding claims,
**wherein**
heat-generating devices arranged in rows (200, 202, 204, 206) are arranged in racks in the room to be cooled, where a rack or a section thereof is replaced by the housing (12) or by the housing and at least one housing part (112) connected thereto.

17. Method for cooling a room with a floor (18) having passage openings and limiting a cavity (20),
**characterized by** the method steps
- arranging a modular-structured arrangement (10, 100) in the room, comprising a cuboid housing (12) with a first side wall designed as a heat exchanger surface of at least one first heat exchanger (32), with a second side wall (28) extending vertical thereto, limited by a first frame (35) and with a door (29), the first frame having a longitudinal piece (38) extending in a plane formed by the first side wall, with a third side wall opposite the first side wall as a rear side wall (23), with a fourth side wall (26) opposite the second side wall with a third frame (27) spanning said fourth side wall with a longitudinal piece (46) extending in the plane formed by the first side wall, with a top wall limiting the side walls at the top, and with at least one fan (14, 16) arranged underneath the housing in the cavity (20) and flow-connected to its interior,
where the housing forms a first module part, the at least one first heat exchanger a second module part, and the at least one fan a third module part,
- where the first and/or third frame(s) is/are removed to increase the cooling capacity, a further housing part (112) is connected to the remaining housing as a fourth module part which has a top part (130) to be connected to the top wall of the remaining housing and a rear part (123) to be connected to the rear side wall of the remaining housing,
- the first and/or third frame(s) is/are connected to the further housing part (112) and
- a further heat exchanger whose heat exchanger surface is aligned with that of the first heat exchanger is inserted into the free space surrounded by the longitudinal piece(s) of the first and/or third frame(s), by the top part (130) of the inserted housing part (112) and by the at least one first heat exchanger provided in the remaining housing.

18. Method according to claim 17,
**wherein**
several corresponding housing parts (112) and corresponding heat exchangers (32, 132) are arranged between the first and/or third frame(s) (35, 27) and the remaining housing.

## Revendications

1. Dispositif modulaire (10, 100) pour refroidir un local dont le fond (18) présentant des orifices de passage délimite un espace creux (20) avec au moins un boîtier (12) de forme parallélépipédique posé sur le sol dont au moins une première paroi latérale est conçue au moins partiellement, de préférence entièrement, comme surface d'échange thermique d'un premier échangeur thermique et dont une seconde paroi latérale est conçue comme porte (29) ou présente une porte, ainsi qu'au moins un ventilateur (14, 16, 114) qui est disposé dans l'espace creux, sachant que le ventilateur est relié fluidiquement à l'espace intérieur du boîtier (12),
**caractérisé en ce**
**que** le dispositif (10, 100) est construit de manière modulaire avec, comme premier module, ledit au moins un premier échangeur thermique (32, 132) constituant la surface d'échange thermique, le boîtier (12) comme deuxième module et ledit au moins un ventilateur (14, 16, 114) comme troisième module, sachant que le boîtier est utilisable ou que des parties du boîtier sont utilisables pour agrandir la surface d'échange thermique pour au moins un autre boîtier juxtaposable à celui-ci ou des parties de boîtiers juxtaposables à celui-ci.

2. Dispositif (10, 100) pour refroidir un local dont le fond (18) présentant des orifices de passage délimite un espace creux (20), comprenant
- au moins un premier échangeur thermique (32) fournissant une surface d'échange thermique,
- un boîtier (12) posé sur le fond, de forme parallélépipédique, avec une première paroi latérale qui est fermée au moins partiellement, de préférence entièrement, par ledit au moins un premier échangeur thermique (32) ou sa surface d'échange thermique, une deuxième paroi latérale (26) s'étendant perpendiculairement à la première paroi latérale, avec une porte (29) ainsi qu'une troisième paroi latérale en face de la première paroi latérale comme paroi arrière (23), une quatrième paroi latérale (26) en face de la deuxième paroi latérale ainsi qu'une paroi supérieure (30) délimitant du côté supérieur les parois latérales,
- au moins un ventilateur (14, 16, 114) disposé dans l'espace creux (20), qui est relié fluidiquement à l'espace intérieur du boîtier (12),
**caractérisé en ce**
**que** le dispositif (10, 100) est construit de manière modulaire avec
- ledit au moins un premier échangeur thermique (32) comme premier module,
- le boîtier (12) comme deuxième module,
- ledit au moins un ventilateur (14, 16) comme troisième module,
sachant que ledit au moins un premier échangeur thermique est accueilli par un cadre délimitant la première paroi latérale ou des sections d'un tel cadre, que la porte (29) est reliée à un premier cadre (35) délimitant ou présentant la deuxième paroi latérale (28), lequel cadre présente un montant de cadre longitudinal (38) qui s'étend dans un plan sous-tendu par la première paroi latérale, sachant qu'au moins une partie de boîtier (112) est insérée comme quatrième module entre le premier cadre (35) avec la porte (29) pour étendre la puissance de refroidissement du dispositif, lequel quatrième module est constitué d'une partie supérieure (130) à fleur de la paroi supérieure (30) et d'une partie arrière (123) à fleur de la paroi arrière (23), et sachant qu'un deuxième échangeur thermique (132) est disposé entre le premier montant de cadre longitudinal (38) et ledit au moins un premier échangeur thermique (32).

3. Dispositif selon la revendication 2,
**caractérisé en ce**
**que** plusieurs parties de boîtier (112) avec chacune un échangeur thermique (132) sont disposées entre le boîtier restant (12) et le premier cadre (35), sachant que les échangeurs thermiques sont disposés avec leur surfaces d'échange thermique alignées et forment une surface essentiellement fermée.

4. Dispositif selon la revendication 2 ou 3,
**caractérisé en ce**
**que** pour étendre la puissance de refroidissement du dispositif (100), un quatrième module (112) ou plusieurs quatrièmes modules sont insérés entre la quatrième paroi latérale (26) en face de la deuxième paroi latérale et le boîtier restant au lieu d'être insérés entre le premier cadre (35) et le boîtier restant.

5. Dispositif (10, 100) selon la revendication 1,
**caractérisé en ce**
**que** le boîtier (12) présente une forme parallélépipédique avec le cadre délimitant les parois et/ou
**que** le boîtier est construit de manière modulaire de telle sorte que la porte (29) est accueillie par un premier cadre (35), que le premier cadre et/ou un troisième cadre (27) en face du premier cadre et sous-tendant la paroi latérale (27) en face de la porte est détachable du boîtier (10) et qu'une autre partie de boîtier (112) est reliable à la partie de boîtier restante, sachant que le premier et/ou troisième cadre forme une paroi telle qu'une paroi latérale de l'autre partie de boîtier (112), et sachant que, de préférence, la paroi présentant la porte (29) est perpendiculaire à l'échangeur thermique ou aux échangeurs thermiques (32, 132).

6. Dispositif (10, 100) selon au moins une des revendications précédentes,
**caractérisé en ce**
**que** des premières parois latérales du boîtier (12) et au moins d'une partie de boîtier (112) reliée à celui-ci, se fondant les unes dans les autres sont conçues comme surfaces d'échange thermique, sachant que les échangeurs thermiques (32, 132) formant les surfaces d'échange thermique sont contigus, notamment bout-à-bout.

7. Dispositif (10, 100) selon au moins une des revendications précédentes,
**caractérisé en ce**
**que** le boîtier (12) juxtaposé à une ou plusieurs autres parties de boîtier (112) forme une unité de boîtier dont une surface latérale longitudinale est conçue comme surface d'échange thermique.

8. Dispositif (10, 100) selon au moins une des revendications précédentes,
**caractérisé en ce**
**que** ledit au moins un ventilateur (14, 16) attribué au boîtier (12) est disposé dans la projection du boîtier en direction du fond (18) en dessous du boîtier et est relié au fond et/ou appuyé sur le plancher de l'espace creux (20).

9. Dispositif (10, 100) selon au moins une des revendications précédentes,
**caractérisé en ce**
**qu'**est attribué à la partie de boîtier (112) au moins un ventilateur (116), de préférence une pluralité de ventilateurs (14, 16) attribuée au boîtier (12), sachant que sont attribués de préférence au boîtier (12) deux ventilateurs dont les côtés d'aspiration s'étendent à l'intérieur de la surface du fond (18), entourée du boîtier (12).

10. Dispositif (10, 100) selon au moins une des revendications précédentes,
**caractérisé en ce**
**que** l'échangeur thermique (32, 132) est relié bout-à-bout à un deuxième cadre (37) entourant la paroi latérale ou est entouré du deuxième cadre côté circonférentiel et est rendu étanche, de préférence par rapport à celui-ci, au moyen par ex. d'un joint en caoutchouc cellulaire et/ou
**que** l'échangeur thermique (32, 132) est pourvu du côté extérieur du boîtier d'un recouvrement perforé tel qu'une tôle perforée.

11. Dispositif (10, 100) selon au moins une des revendications précédentes,
**caractérisé en ce**
**que** le fond (18) est appuyé sur le plancher de l'espace creux (20) au moins directement en dessous du boîtier (12) ou de la partie de boîtier (112) et que dans cette zone, ledit au moins un ventilateur (14, 16, 114) est relié au fond (18).

12. Dispositif (10, 100) selon au moins une des revendications précédentes,
**caractérisé en ce**
**que** le dispositif (100) se compose d'un boîtier et d'au moins une autre partie de boîtier (12, 112), que le dispositif est praticable, qu'un côté longitudinal du dispositif est conçu comme surface d'échange thermique qui est constituée par des échangeurs thermiques (32, 132) assemblés bout-à-bout, qu'une paroi avant du dispositif est conçue au moins partiellement comme porte (29) qui est accueillie par le premier cadre (35) qui est relié aux montants de cadre (40, 42, 140, 142) du boîtier ou de la partie de boîtier à fermer, attribués côté avant, et qu'au moins un ventilateur radial (14, 16, 114) relié à la zone du fond (18) soutenant le boîtier et ladite au moins une partie de boîtier est attribué au boîtier et à chaque partie de boîtier.

13. Dispositif (10, 100) selon au moins une des revendications précédentes,
**caractérisé en ce**
**que** le boîtier (12), de préférence le boîtier avec au moins une partie de boîtier (112) reliée à celui-ci, avoisine directement une paroi intérieure du local, sachant que la paroi du boîtier ou de la partie de boîtier, s'étendant le long de ladite au moins une paroi intérieure est retirée et/ou que le boîtier (12) ou une unité constituée du boîtier et d'au moins une partie de boîtier tient debout sur le fond (18) sans fixation.

14. Dispositif (10, 100) selon au moins une des revendications précédentes,
**caractérisé en ce**
**que** l'échangeur thermique (32, 132) est relié à une délimitation du local ou que l'échangeur thermique (32, 132) est entouré par un cadre qui est rendu étanche par rapport au deuxième cadre (37) formé du boîtier (12) ou du boîtier et d'au moins une partie de boîtier (112) et par rapport à un autre échangeur thermique éventuellement présent.

15. Dispositif (10, 100) selon au moins une des revendications précédentes,
**caractérisé en ce**
**que** le dispositif (10, 110) se composant du boîtier (12) et d'au moins une partie de boîtier (112) est constitué d'une paroi supérieure fermée, d'une première paroi avant fermée (26) et d'une paroi latérale fermée (23), que la première paroi latérale située en face de la paroi latérale (23) est formée au moins par un échangeur thermique (32, 132) et que la paroi avant située en face de la première paroi avant présente une porte (29).

16. Dispositif (10, 100) selon au moins une des revendications précédentes,
**caractérisé en ce**
**que** dans le local à refroidir, des appareils produisant de la chaleur disposés en rangées (200, 202, 204, 206) sont placés dans des châssis, sachant qu'un châssis ou une section de celui-ci est remplacé(e) par le boîtier (12) ou par le boîtier et au moins une partie de boîtier (112) reliée à celui-ci.

17. Procédé destiné à refroidir un local avec un fond (18) délimitant un espace creux (20) et présentant des orifices de passage,
**caractérisé par** les étapes de procédé suivantes :
- Positionnement, dans le local, d'un dispositif (10, 100) construit de manière modulaire comprenant un boîtier (12) de forme parallélépipédique avec une première paroi latérale conçue comme surface d'échange thermique d'au moins un premier échangeur thermique (32), d'une seconde paroi latérale (28) avec une porte (29), s'étendant perpendiculairement à celle-ci et délimitée par un premier cadre (35), sachant que le premier cadre présente un montant longitudinal (38) qui s'étend dans un plan sous-tendu par la première paroi latérale, avec, comme paroi arrière (23), une troisième paroi latérale en face de la première paroi latérale, avec une quatrième paroi latérale (26) en face de la deuxième paroi latérale avec un troisième cadre (27) sous-tendant celle-ci et comportant un montant longitudinal (46) qui s'étend dans le plan sous-tendu par la première paroi latérale, avec une paroi supérieure délimitant côté supérieur les parois latérales ainsi qu'au moins un ventilateur (14, 16) disposé en dessous du boîtier dans l'espace creux (20) et relié fluidiquement à son espace intérieur,
sachant que le boîtier forme un premier module, ledit au moins un premier échangeur thermique un deuxième module et ledit au moins un ventilateur un troisième module,
- sachant qu'est retiré pour étendre la puissance de refroidissement, le premier et/ou le troisième cadre, qu'une autre partie de boîtier (112) est reliée au boîtier restant, formant un quatrième module qui présente un élément supérieur (130) à relier à la paroi supérieure du boîtier restant et un élément arrière (123) à relier à la paroi arrière du boîtier restant,
- que le premier et/ou troisième cadre est relié à l'autre partie de boîtier (112) et
- que dans l'espace libre entouré du montant longitudinal du premier et/ou du troisième cadre, de la partie supérieure (130) de la partie de boîtier insérée (112) et dudit au moins un premier échangeur thermique présent dans le boîtier restant est placé un autre échangeur thermique dont la surface d'échange thermique est orientée vers celle du premier échangeur thermique.

18. Procédé selon la revendication 17,
**caractérisé en ce,**
**que** plusieurs parties de boîtier correspondantes (112) et échangeurs thermiques (32, 132) correspondants sont disposés entre le premier et/ou troisième cadre (35, 27) et le boîtier restant.
